# EUROPEAN PATENT APPLICATION

(11) **EP 2 028 696 A2**
(43) Date of publication of application: **25.02.2009**
(21) Application number: 08252803.5
(22) Date of filing: 22.08.2008
(51) Int. Cl.: H01L 31/048

(54) **Solar cell and solar cell module**

(30) Priority: 24.08.2007 JP 2007219076; 23.04.2008 JP 2008113198
(71) Applicant: Sanyo Electric Co., Ltd., Osaka 570-8677 (JP)
(72) Inventor: Nishida, Toyozo , c/o Sanyo Electric Co., Ltd., Moriguchi-shi, Osaka 570-8677 (JP); Ninomiya, Kunimoto, c/o Sanyo Electric Co.,, Moriguchi-shi,Osaka 570-8677 (JP)
(74) Representative: Calderbank, Thomas Roger

(57) **Abstract**

Solar cells each include: an insulator connected to a back surface of a photoelectric conversion part; a first through-hole electrode penetrating the insulator, and electrically connected to a first collector electrode; and a second through-hole electrode penetrating the insulator, and electrically connected to a second collector electrode. In addition, a wiring member is disposed on the insulator.

## Description

This application is based upon and claims the benefit of priority from the prior Japanese Patent Application No. P 2007-219076 filed on August 24, 2007, and the prior Japanese Patent Application No. P 2008-113198 filed on April 23, 2008; the entire contents of which are incorporated herein by reference.

The present invention relates to a solar cell with a wiring member thermally bonded only to a back surface side of the solar cell, and a solar cell module including such solar cells.

A solar cell directly converts sunlight, which is clean and is supplied without limit, to electricity. Because of this characteristic, solar cells are expected to be a new energy source.

Energy output per solar cell is on the order of several W. Accordingly, when solar cells are used as power source for a house, a building or the like, generally used is a solar cell module in which multiple solar cells are connected to each other with wiring members.

In general, a solar cell includes a pair of positive and negative electrodes disposed on a light-receiving surface, for receiving sunlight, and a back surface reverse of the light-receiving surface. A wiring member is thermally bonded to an electrode disposed on the light-receiving surface of one solar cell and an electrode disposed on the back surface of a different solar cell adjacent to the one solar cell (see Japanese Patent Application Publication No. 2005-217148, for example).

In such a configuration, the linear expansion coefficient of a wiring member is larger than that of a semiconductor substrate composing a solar cell. For this reason, after the thermal bonding, contraction force of the wiring member arises at a boundary surface between the wiring member and the solar cell.

As described above, when wiring members are thermally bonded to a light-receiving surface and a back surface of a solar cell, contraction force is applied to the solar cell from both the light-receiving surface and the back surface. Accordingly, influence of the contraction force on the solar cell is reduced to some extent.

Energy output of the solar cell is approximately proportional to a light-receiving area in a light-receiving surface. Accordingly, expansion of a light-receiving area of a solar cell is considered to be possible by disposing a pair of positive and negative electrodes on a back surface of the solar cell and bonding wiring members on the back surface side of the solar cell.

Specifically, one wiring member is thermally bonded to a positive electrode disposed on a back surface of one solar cell and a negative electrode disposed on a back surface of a different solar cell adjacent to the one solar cell. Similarly, a different wiring member is thermally bonded to a negative electrode disposed on the back surface of the one solar cell and a positive electrode disposed on a back surface of a still different solar cell adjacent to the one solar cell.

When wiring members are thermally bonded only to a back surface side of a solar cell as described above, concentration force of the wiring members are applied only to the back surface of the solar cell, which may cause the solar cell to curve.

In particular, such a curve of a solar cell is likely to more significantly occur as solar cells are reduced in thickness for the purpose of reducing manufacturing cost. Accordingly, thermally bonding a wiring member only to a back surface side of a solar cell prevents reduction in thickness of the solar cell.

The present invention has been made in view of the above-described problem. An object of the present invention is to provide: a solar cell with less influence of contraction force of a wiring member when the wiring is thermally bonded only to a back surface side of the solar cell; and a solar cell module including such solar cells.

A solar cell module according to an aspect of the present invention includes a first solar cell, and a second solar cell electrically connected to the first solar cell with a wiring member. In this solar cell module, the first solar cell and the second solar cell are arranged in arrangement direction. Moreover, the first solar cell and the second solar cell each include: a photoelectric conversion part including a light-receiving surface and a back surface provided on a reverse side of the light-receiving surface, and configured to generate electrons and holes by receiving light; a first collector electrode formed on the photoelectric conversion part, and configured to collect the electrons; a second collector electrode formed on the photoelectric conversion part, and configured to collect the holes; an insulator connected to the back surface of the photoelectric conversion part; a first through-hole electrode penetrating the insulator, and electrically connected to the first collector electrode; and a second through-hole electrode penetrating the insulator, and electrically connected to the second collector electrode. In addition, the wiring member is electrically connected to the first through-hole electrode included in the first solar cell and the second through-hole electrode included in the second solar cell, on the insulator.

Thus, the first solar cell and the second solar cell each include the insulator connected to the back surface of the corresponding photoelectric conversion part. With this configuration, the insulators can absorb contraction force and expansion force of the wiring members associated with temperature change. Accordingly, the photoelectric conversion parts are less likely to curve due to contraction force or expansion force of the wiring members. Consequently, the first solar cell and the second solar cell are less likely to be cracked or chipped.

In the solar cell module according to another aspect of the present invention, the first collector electrode may be formed on the light-receiving surface of the photoelectric conversion part, and the second collector electrode may be formed on the back surface of the photoelectric conversion part. In addition, the first through-hole electrode may penetrate the photoelectric conversion part.

In the solar cell module according to another aspect of the present invention, the photoelectric conversion part may include an n-type region provided in the back surface and a p-type region provided in the back-surface. In addition, the first collector electrode may be disposed on the n-type region, and the second collector electrode may be disposed on the p-type region.

In the solar cell module according to another aspect of the present invention, the first through-hole electrode included in the first solar cell and the second through-hole electrode included in the second solar cell may be linearly arranged in the arrangement direction, in a plan view from a back-surface side.

In the solar cell module according to another aspect of the present invention, the insulator included in any one of the first solar cell and the second solar cell may be formed of a resin material containing a plurality of particles.

In the solar cell module according to another aspect of the present invention, surface processing may be applied to the insulator included in any one of the first solar cell and the second solar cell, the surface processing for enabling the insulator to diffuse light.

In the solar cell module according to another aspect of the present invention, the insulator included in the first solar cell and the insulator included in the second solar cell may be integrally formed in a flat plate shape.

In the solar cell module according to another aspect of the present invention, the wiring member may include: a first wiring member arranged in the arrangement direction, and connected to the first through-hole electrode included in the first solar cell; and a second wiring member arranged in the arrangement direction, and connected to the second through-hole electrode included in the second solar cell. Moreover, the first solar cell may include a third wiring member arranged on the insulator in orthogonal direction substantially orthogonal to the arrangement direction. Furthermore, the first wiring member and the second wiring member may each be electrically connected to the third wiring member.

In this case, in a plan view from the back-surface side, the first through-hole electrode included in the first solar cell and the second through-hole included in the second solar cell are disposed on a line intersecting the arrangement direction. In addition, the first solar cell may include a third collector electrode electrically connected to the second collector electrode. Here, the third collector electrode may be formed in the orthogonal direction on the back surface of the photoelectric conversion part.

A solar cell according to another aspect of the present invention includes: a photoelectric conversion part including a light-receiving surface and a back surface provided on a reverse side of the light-receiving surface, and configured to generate electrons and holes by receiving light; a first collector electrode formed on the photoelectric conversion part, and configured to collect the electrons; a second collector electrode formed on the photoelectric conversion part, and configured to collect the holes; an insulator connected to the back surface of the photoelectric conversion part; a first through-hole electrode penetrating the insulator, and electrically connected to the first collector electrode; and a second through-hole electrode penetrating the insulator, and electrically connected to the second collector electrode.

According to the present invention, a solar cell with less influence of contraction force of a wiring member when the wiring member is thermally bonded only to a back surface side of the solar cell, and a solar cell module including such solar cells, can be provided.

### IN THE DRAWINGS

Fig. 1 is a side view of a solar cell module 1 according to a first embodiment.
Fig. 2 is a top view of a solar cell string 101 according to the first embodiment.
Fig. 3 is a back view of the solar cell string 101 according to the first embodiment.
Fig. 4 is a cross-sectional view taken along a line A-A in Fig. 3.
Fig. 5 is a cross-sectional view taken along a line B-B in Fig. 3.
Fig. 6 is a cross-sectional view taken along a line C-C in Fig. 3.
Fig. 7 is a back view of a solar cell string 102 according to a second embodiment.
Fig. 8 is a back view of insulators 14 according to the second embodiment.
Fig. 9 is a cross-sectional view taken along a line D-D in Fig. 7.
Fig. 10 is a back view of a solar cell string 103 according to a third embodiment.
Fig. 11 is a back view of insulators 14 according to the third embodiment.
Fig. 12 is a back view of a solar cell 10a and a solar cell 10b according to the third embodiment.
Fig. 13 is a cross-sectional view taken along a line E-E in Fig. 10.
Fig. 14 is a side view of a solar cell module 2 according to a fourth embodiment.
Fig. 15 is a back view of a solar cell string 104 according to the fourth embodiment.
Fig. 16 is a top view of the solar cell string 104 according to the fourth embodiment.
Fig. 17 is an enlarged cross-sectional view taken along a line F-F in Fig. 15.
Fig. 18 is a back view of a solar cell string 105 according to a fifth embodiment.
Fig. 19 is a top view of the solar cell string 105 according to the fifth embodiment.
Fig. 20 is a back view of a solar cell 10d according to the fifth embodiment.
Fig. 21 is an enlarged cross-sectional view taken along a line G-G in Fig. 18.
Fig. 22 is an enlarged cross-sectional view taken along a line H-H in Fig. 18.
Fig. 23 is a back view of a solar cell string 106 according to a sixth embodiment.
Fig. 24 is a back view of a solar cell 10e according to the sixth embodiment.
Figs. 25A and 25B are respectively a back view and a top view of an insulator 114 according to the sixth embodiment.
Fig. 26 is an enlarged cross-sectional view taken along a line I-I in Fig. 23.
Fig. 27 is a back view of a solar cell string 107 according to a seventh embodiment.
Fig. 28 is a top view of the solar cell string 107 according to the seventh embodiment.
Fig. 29 is a back view of a solar cell 10f according to the seventh embodiment.
Fig. 30 is an enlarged cross-sectional view taken along a line J-J in Fig. 27.
Fig. 31 is an enlarged cross-sectional view taken along a line K-K in fig. 27.
Fig. 32 is an enlarged cross-sectional view taken along a line L-L in Fig. 27.

Hereinbelow, embodiments of the present invention will be described with reference to the accompanying drawings. In description of the drawings, the same or similar parts are denoted by the same or similar reference numerals. It should be noted that the drawings are merely schematic, and that dimensional proportions in the drawings are different from those in practice. Accordingly, concrete dimensions and the like should be understood on the basis of the following description. Moreover, there are naturally some differences in dimensional relationships and proportions between the drawings.

### [First Embodiment]

### (Configuration of Solar Cell Module)

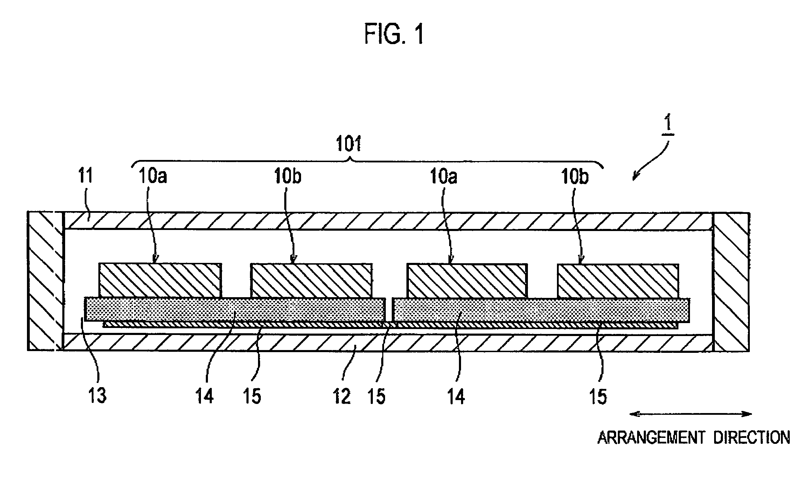

A configuration of a solar cell module according to a first embodiment will be described with reference to Fig. 1. Fig. 1 is a side view of a solar cell module 1 according to the first embodiment.

As shown in Fig. 1, the solar cell module 1 includes a solar cell string 101, a light-receiving-surface-side protection member 11, a back-surface-side protection member 12, and a sealing member 13.

The solar cell string 101 includes a plurality of solar cells 10 and wiring members 15. The plurality of solar cells 10 includes solar cells 10a and solar cells 10b alternately disposed in arrangement direction as shown in Fig. 1. The solar cells 10a and the solar cells 10b are electrically connected to each other in series with the wiring members 15. In the first embodiment, pairs of the solar cells 10a and 10b adjacent to each other share the insulators 14, respectively. A configuration of the insulators will be described later.

The light-receiving-surface-side protection member 11 is disposed on a top surface side of the solar cell module 1 to protect light-receiving-surface sides of the plurality of solar cells 10. The light-receiving-surface-side protection member 11 can be formed of glass or plastic with translucency and resistance to weather.

The back-surface-side protection member 12 is disposed on a back-surface side of the solar cell module 1 to protect back surface sides of the plurality of solar cells 10. The back-surface-side protection member 12 can be formed of materials having resistance to weather such as glass, plastic, a single-layer body of resin film, or a laminated body of resin films with a metal foil sandwiched therebetween.

The sealing member 13 seals the plurality of solar cells 10 between the light-receiving-surface-side protection member 11 and the back-surface-side protection member 12. The sealing member 13 can be formed of translucent resin such as EVA, EEA or PVB.

### (Configuration of Solar Cell String)

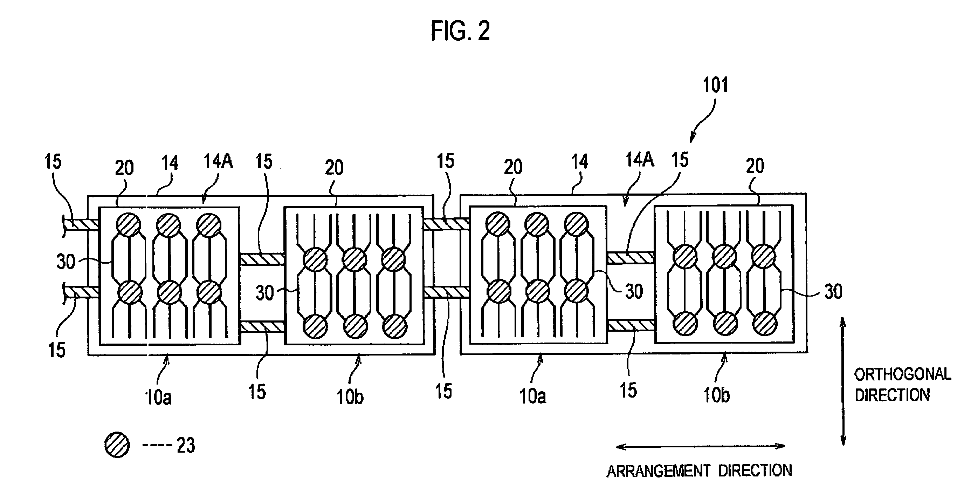

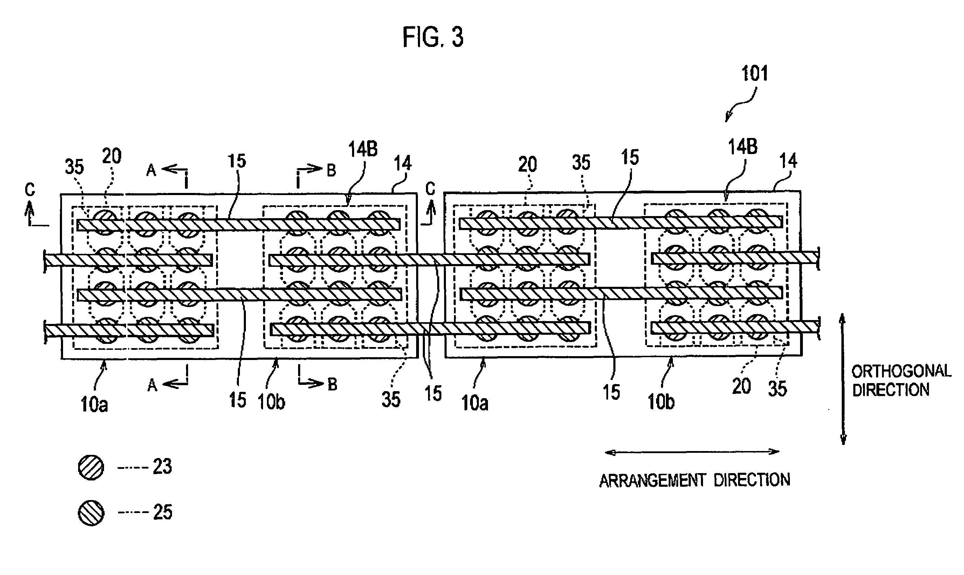

Fig. 2 is a top view of the solar cell string 101, and Fig. 3 is a back view of the solar cell string 101.

The solar cell string 101 includes the solar cells 10a, the solar cells 10b, and the wiring members 15.

As shown in Figs. 2 and 3, the solar cells 10a and the solar cells 10b have the same configuration. In particular, each of the solar cells 10a and the solar cells 10b includes a photoelectric conversion part 20, a first collector electrode 30, a second collector electrode 35, a plurality of first through-hole electrodes 23, and a plurality of second through-hole electrodes 25. In the first embodiment, the pair of the solar cells 10a and the solar cells 10b adjacent to each other shares the insulator 14, respectively.

Note that the arrangement of the solar cells 10a is rotated by 180° around the center of an axis passing through the center of the corresponding light-receiving surface, in relation to that of the solar cells 10b.

Each of the photoelectric conversion parts 20 includes a light-receiving surface, which receives light, and a back surface, which is on the reverse side of the light-receiving surface. The photoelectric conversion part 20 has a semiconductor junction, such as a semiconductor p-n junction or a semiconductor p-i-n junction, as a fundamental structure. The photoelectric conversion part 20 generates photocarriers by receiving light. Photocarriers are electrons and holes which are generated through a process in which the photoelectric conversion part 20 absorbs sunlight. A configuration of the photoelectric conversion parts 20 will be described later in detail.

The first collector electrode 30 is formed on the light-receiving surface of the photoelectric conversion part 20. The first collector electrode 30 collects the photocarriers, generated by the photoelectric conversion part 20, from the photoelectric conversion part 20. The first collector electrode 30 can be formed of thermosetting resin paste or so-called ceramic paste.

The second collector electrode 35 is formed on the back surface of the photoelectric conversion part 20. The second collector electrode 35 collects the photocarriers, generated by the photoelectric conversion part 20, from the photoelectric conversion part 20. The second collector electrode 35 can be formed of thermosetting resin paste or so-called ceramic paste.

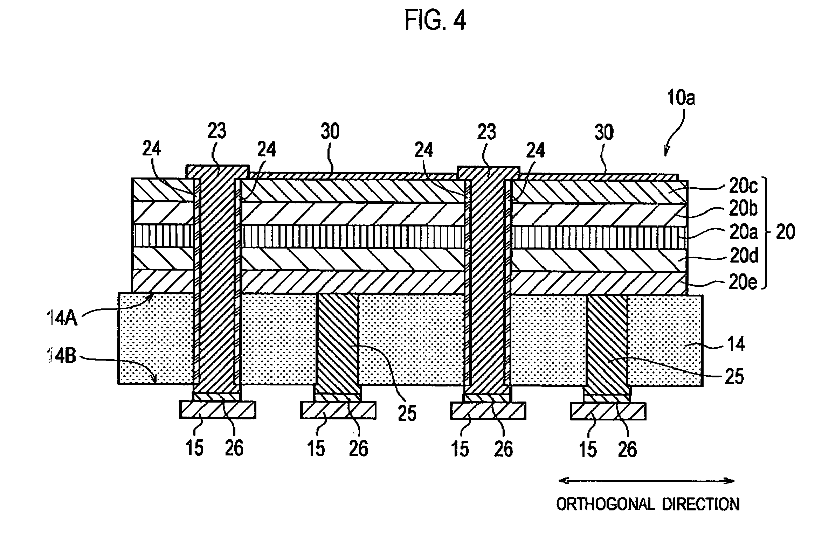

The first through-hole electrodes 23 each penetrate the photoelectric conversion part 20 and the corresponding insulator 14 (see Fig. 4). One end of the first through-hole electrode 23 is electrically connected to the first collector electrode 30. The other end of each of the first through-hole electrodes 23 is electrically connected to the corresponding wiring member 15. The first through-hole electrodes 23 can be made of thermosetting resin paste or so-called ceramic paste. In the first embodiment, three first through-hole electrodes 23 arranged in the arrangement direction are arranged in two rows along the orthogonal direction.

The second through-hole electrodes 25 each penetrate the corresponding insulator 14 (see Fig. 4). The first through-hole electrodes 23 and the second through-hole electrodes 25 are alternately arranged in the orthogonal direction. One end of the second through-hole electrode 25 is electrically connected to the second collector electrode 35. The other end of each of the through-hole electrodes 25 is electrically connected to the corresponding wiring member 15. The second through-hole electrodes 25 can be formed of thermosetting resin paste or so-called ceramic paste. In the first embodiment, three second through-hole electrodes 25 arranged in the arrangement direction are arranged in two rows along the orthogonal direction.

As shown in Fig. 3, each row of the three first through-hole electrodes 23 of the solar cells 10a and a corresponding row of the three second through-hole electrodes 25 of the solar cells 10b are arranged linearly along the arrangement direction. Similarly, each row of the three second through-hole electrodes 25 of the solar cells 10a and a corresponding row of the three first through-hole electrodes 23 of the solar cells 10b are arranged linearly along the arrangement direction.

Each of the insulators 14 is formed of a material with electrical insulating properties, and is formed into a flat-plate shape. The insulator 14 is arranged so as to cover the back surface of the photoelectric conversion part 20 of the corresponding solar cell 10a and the corresponding solar cell 10b. The insulator 14 has a first main surface 14A facing the back surfaces of the photoelectric conversion parts 20, and a second main surface 14B on the reverse side of the first main surface 14A. Thus, each of the solar cell 10a and the solar cell 10b has the insulators 14, and the second main surface 14B forms a back surface of the solar cell 10a and the solar cell 10b.

Here, it is preferable that the material composing the insulators 14 be chosen in accordance with the intended use of the insulators 14. The material to be preferably chosen will be described below for each possible main intended use of the insulators 14.

### (1) To suppress deformation of solar cells 10

When the insulators 14 are used to suppress deformation of the solar cells 10, the insulators 14 are preferably composed of a material with high Young's modulus (i.e. with high resistance to external forces). Specifically, the insulators 14 can be composed of a thermosetting resin material such as epoxy resin, or an inorganic material such as ceramics.

When a resin material is used for the insulators 14, the insulators 14 become adhesive by heating. In such a case, the insulators 14 can be attached to the photoelectric conversion parts 20 without using any bonding material. By contrast, when an inorganic material is used for the insulators 14, the insulators 14 are attached to the solar cells 10 with a bonding material or the like.

### (2) To reduce contraction force of wiring members 15

When the insulators 14 are used to reduce contraction force and expansion force of the wiring members 15 associated with temperature change, the insulators 14 are preferably composed of a resin material with flexibility such as silicone or EVA. Contraction force and expansion force of the wiring members 15 are absorbed by the insulators 14 with flexibility.

### (3) To reflect or diffuse incident light

The insulators 14 preferably have a function of reflecting or diffusing incident light. By using the insulators 14 with such a function, incident light can be efficiently guided to the solar cells 10. This function can be obtained by forming the insulators 14 of a resin material mixed with multiple particles, or through machine processing such as prism processing or another type of surface processing. Titanium oxide particles or silicon dioxide particles can be used as the multiple particles. When EVA is used for the insulators 14, fine prism processing can be applied directly to the EVA.

### (4) To securely provide insulation properties between wiring members 15 and solar cells 10

In order to sufficiently reduce the occurrence of short circuit between the wirings 15 and the solar cells 10, surfaces of the insulators 14 are preferably coated with a resin material having high insulation properties. As such a coating material, imide, amide, polyimide, polyamide, or polysilazane can be used, for example.

Next, as shown in Fig. 3, the wiring members 15 are each arranged in the arrangement direction on the second main surfaces 14B of the insulators 14. The wiring members 15 electrically connect the solar cells 10a and the solar cells 10b. The wiring members 15 can each be formed of a conductive member such as copper formed into a thin plate shape or a twisted line shape. In addition, surfaces of the wiring members 15 may be plated with solder or the like.

Some of the wiring members 15 are each electrically connected to a row of the three first through-hole electrodes 23 of the corresponding solar cell 10a and a row of the three second through-hole electrodes 25 of the corresponding solar cell 10b. Similarly, the rest of the wiring members 15 are each electrically connected to a row of the three second through-hole electrodes 25 of the corresponding solar cell 10a and a row of the three first through-hole electrodes 23 of the corresponding solar cell 10b. Thereby, the solar cells 10a and the solar cells 10b are electrically connected to each other in series.

### (Configuration of Solar Cells)

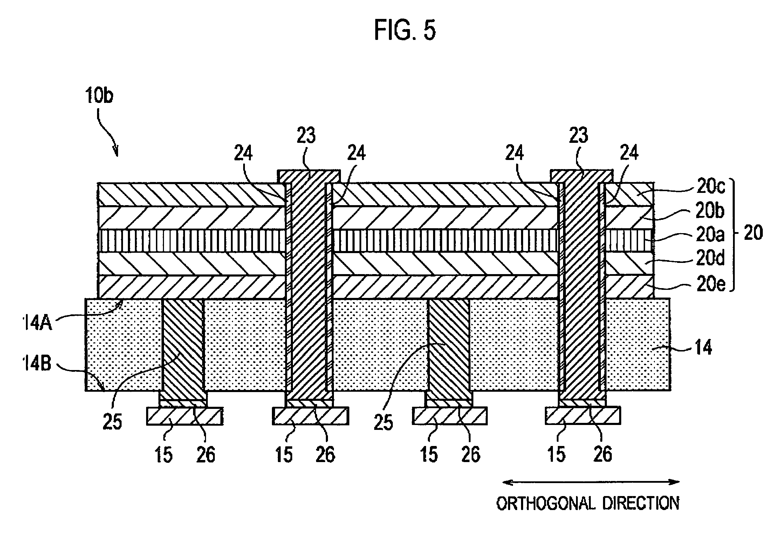

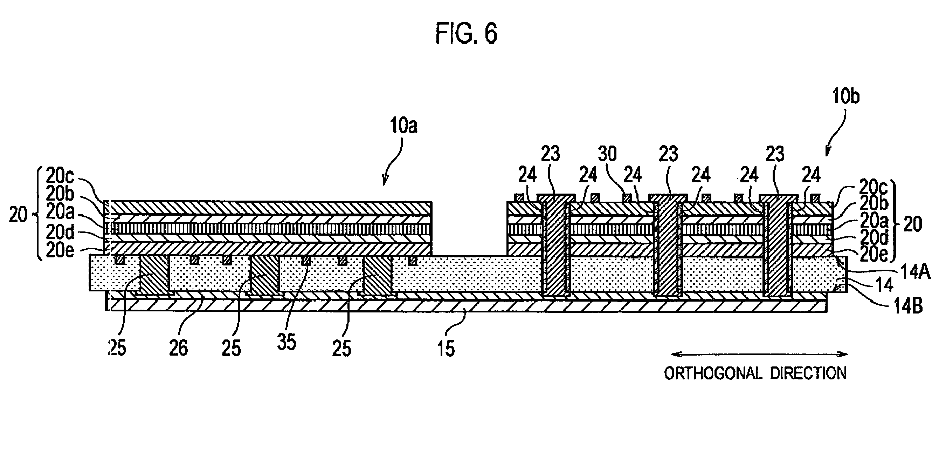

Next, a configuration of the solar cells 10a and the solar cells 10b will be described with reference to Figs. 4 to 6. Fig. 4 is a cross-sectional view taken along a line A-A in Fig. 3, Fig. 5 is a cross-sectional view taken along a line B-B in Fig. 3, and Fig. 6 is a cross-sectional view taken along a line C-C in Fig. 3.

As shown in Figs. 4 to 6, the photoelectric conversion parts 20 each include a semiconductor substrate 20a, a first semiconductor layer 20b, a transparent conductive film 20c, a second semiconductor layer 20d and a transparent conductive film 20e.

The semiconductor substrate 20a can be formed of a crystal-based semiconductor material such as single crystal Si or polycrystalline Si, or a compound semiconductor material such as GaAs or InP.

The first semiconductor layer 20b and the second semiconductor layer 20d have different conductivity types. The transparent conductive films 20c and 20e can be formed of ITO (Indium Tin Oxide) or the like.

Here, the photoelectric conversion parts 20 may each have a so-called HIT structure, that is, a structure having a single-crystal silicon substrate and an amorphous silicon layer with an intrinsic amorphous silicon layer sandwiched therebetween.

As shown in Fig. 4, the first through-hole electrodes 23 each penetrate the photoelectric conversion part 20 and the insulator 14, that is, from the light-receiving surface of the photoelectric conversion part 20 to the second main surface 14B of the insulator 14. Each of the first through-hole electrodes 23 is formed into a columnar shape, and the surface thereof is covered with an insulating layer 24. One end of the first through-hole electrode 23 is electrically connected to the first collector electrode 30, on the light-receiving surface of the photoelectric conversion part 20. The other end of the first through-hole electrode 23 is electrically connected to the corresponding wiring member 15, on the second main surface 14B of the insulator 14. Between the first through-hole electrode 23 and the wiring member 15, a conductive bonding material 26 is interposed. A resin bonding material containing conductive metallic particles or solder can be used as the conductive bonding material 26.

The insulating layer 24 can be formed of an existing insulating material. The insulating layer 24 electrically separates the first through-hole electrode 23 and the photoelectric conversion part 20. Here, the insulating layer 24 need not be formed between the first through-hole electrode 23 and the insulator 14.

As shown in Fig. 4, the second through-hole electrodes 25 each penetrate the insulator 14 from the first main surface 14A to the second main surface 14B. One end of the second through-hole electrode 25 is electrically connected to the second collector electrode 35, on the back surface of the photoelectric conversion part 20. The other end of the second through-hole electrode 25 is electrically connected to the corresponding wiring member 15, on the second main surface 14B of the insulator 14. Between the second through-hole electrode 25 and the wiring member 15, the conductive bonding material 26 is interposed.

As shown in Fig. 6, the conductive bonding material 26 is arranged in the arrangement direction between the insulator 14 and the wiring members 15. Thereby, the wiring members 15 are firmly bonded to the second main surface 14B of the insulator 14.

Figs. 4 to 6 show a case in which the insulator 14 is composed of a resin material such as silicone or EVA. Accordingly, no bonding material or the like is provided between the insulator 14 and the solar cells 10.

### (Method of manufacturing solar cell module)

Next, an example of a method of manufacturing the solar cell module 1 will be described.

Firstly, the first semiconductor layer 20b and the second semiconductor layer 20d are each formed on the semiconductor substrate 20a by means of a CVD method.

Then, an ITO film (the transparent conductive film 20c) is formed on the first semiconductor layer 20b by means of a sputtering method. Similarly, an ITO film (the transparent conductive film 20e) is formed on the second semiconductor layer 20d. Thereby, the photoelectric conversion part 20 is formed.

Thereafter, by means of a printing method such as a screen printing method, thermosetting conductive paste is printed on the light-receiving surface and the back surface of the photoelectric conversion part 20 to form a predetermined pattern thereon. Thereby, the first collector electrode 30 and the second collector electrode 35 are formed. As the conductive paste, epoxy-based thermosetting silver paste can be used, for example.

The plurality of photoelectric conversion parts 20 each including the first collector electrodes 30 or the second collector electrodes 35 formed thereon are then arranged in the arrangement direction, while each being half-turned in relation to the adjacent photoelectric conversion parts 20.

Subsequently, a resin sheet (the insulator 14) is disposed on the back surfaces of each pair of the photoelectric conversion parts 20. Then, two rows of three first through-holes penetrating the corresponding photoelectric conversion part 20 and the resin sheet are formed so as to each align in the arrangement direction, by using a CO₂ laser or an excimer laser. Similarly, two rows of three second through-holes penetrating the resin sheet are formed so as to each align in the arrangement direction. Here, the rows of first through-holes and the rows of second through-holes are alternately formed in the orthogonal direction.

Thereafter, an insulating material such as polysilazane is applied to the inner wall of each of the first through-holes. Thereby, insulation finishing (the insulating layer 24) is provided to the inner wall of each of the first through-holes.

Then, thermosetting conductive paste is filled into the six first through-holes and the six second through-holes by using a printing method such as a screen printing method. As the conductive paste, epoxy-based thermosetting silver paste can be used, for example. Thereby, the six first through-hole electrodes 23 and the six second through-hole electrodes 25 are formed, and the solar cell 10a and the solar cell 10b are consequently manufactured.

Subsequently, the corresponding wiring 15 is thermally bonded to the three first through-hole electrodes 23 in each row in the solar cell 10a and the three second through-hole electrodes 25 in the corresponding row in the solar cell 10b, with the conductive bonding material 26 interposed therebetween. Similarly, the corresponding wiring 15 is thermally bonded to the three second through-hole electrodes 25 in each row in the solar cell 10a and the three first through-hole electrodes 23 in the corresponding row in the solar cell 10b, with the conductive bonding material 26 interposed therebetween. Thereby, the solar cell string 101 consequently manufactured.

Then, a laminated body is formed on a glass substrate (the light-receiving-surface-side protection member 11) by sequentially stacking an EVA sheet (the sealing member 13), the solar cell string 101, the EVA sheet (the sealing member 13), and a PET film (the back-surface-side protection member 12) thereon.

Thereafter, the laminated body is thermocompressively bonded in a vacuum atmosphere to cause the EVA to be cross-linked. Through the above-described process, the solar cell module 1 is manufactured. Here, a terminal box, an Al frame or the like can be attached to the solar cell module 1.

### (Functions and Effects)

In the first embodiment, each of the solar cells 10a and the solar cells 10b includes the corresponding insulator 14 attached to the back surface of the photoelectric conversion part 20.

With this configuration, the insulators 14 can absorb contraction force and expansion force of the wiring members 15 associated with temperature change. Accordingly, the photoelectric conversion parts 20 are less likely to curve due to contraction force or expansion force of the wiring members 15. Consequently, the solar cells 10a and the solar cells 10b are less likely to be cracked or chipped.

The solar cell 10a and the solar cell 10b of each pair share the insulator 14 integrally formed into a flat plate shape. Accordingly, stress can be prevented from concentrating at arrangement-direction end portions of each of the solar cell 10a and the solar cell 10b in the modularization process. Consequently, the solar cell 10a and the solar cell 10b are less likely to be cracked or chipped at the end portions.

Moreover, when the insulators 14 are formed by a resin material containing multiple particles, or when a surface processing for diffusing light is applied to the insulators 14, the insulators 14 can reflect or diffuse incident light. Consequently, a larger amount of incident light can be guided to the solar cells 10a and the solar cells 10b. This function is effective for a double-sided power generation solar cell which uses even the incident light from the back sides of the photoelectric conversion parts 20. In addition, as solar cells become thinner, the amount of light passing through each solar cell itself increases. In light of this, it is especially effective for a thin double-sided power generation solar cell to have the insulators 14 with such a function of reflecting or diffusing incident light.

When the insulators 14 are formed by a resin material containing multiple particles, the bond of the resin material is separated by the multiple particles. Accordingly, the bond of the resin material is weakened; thereby, the degree at which the insulators 14 absorb external forces increases.

### [Second Embodiment]

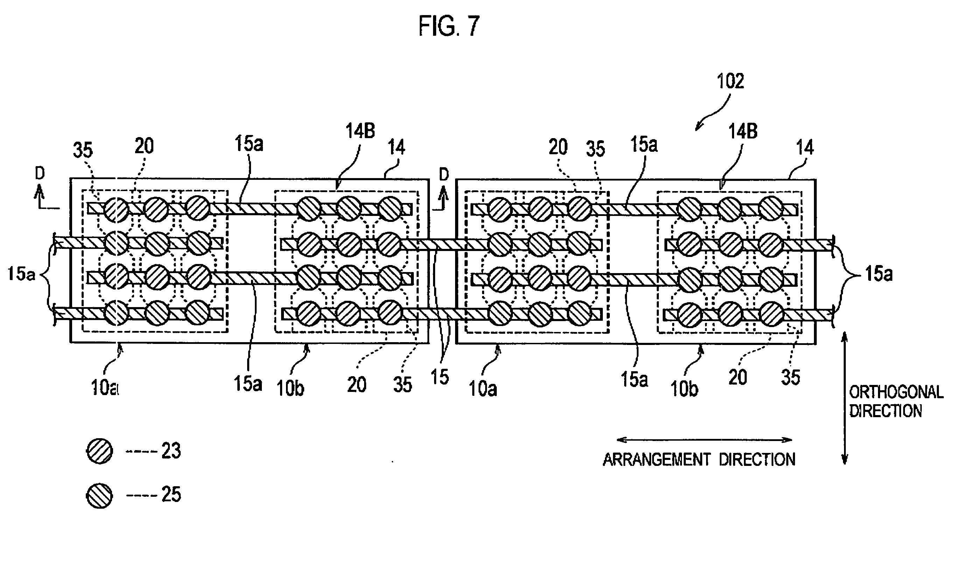

A second embodiment will be described below with reference to Figs. 7 to 9. In the second embodiment, insulators are each provided with through-holes and conductive members (wiring members) in advance. In the following description, explanations of portions the same as or similar to those in the first embodiment are omitted.

### (Configuration of Solar Cell String)

Fig. 7 is a back view of a solar cell string 102 according to the second embodiment. As shown in Fig. 7, rows of first through-hole electrodes 23 (or rows of second through-hole electrodes 25) of solar cells 10a are electrically connected with rows of the second through-hole electrodes 25 (or rows of the first through-hole electrodes 23) of solar cells 10b with conductive members 15a, respectively.

### (Configuration of Insulators)

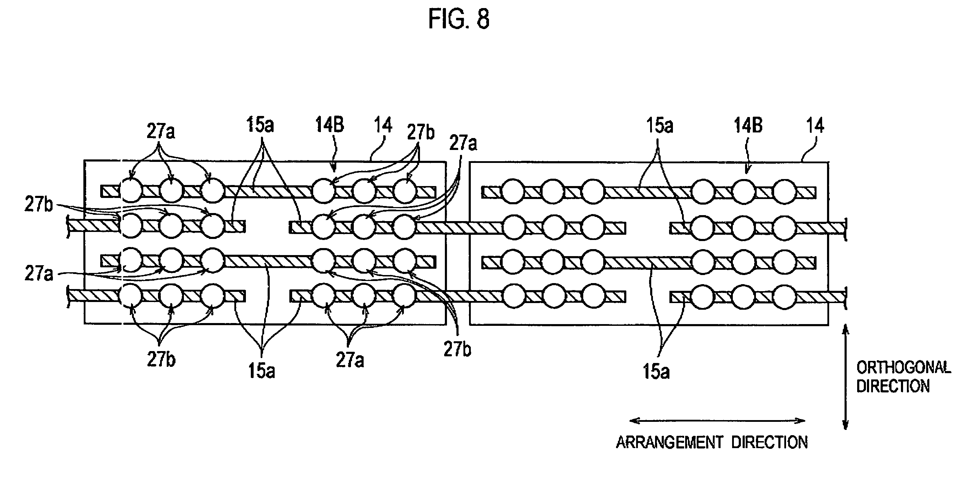

Fig. 8 is a back view of insulators 14 according to the second embodiment. The insulators 14 are each provided with first insulator through-holes 27a, second insulator through-holes 27b, and the conductive members 15a.

Each of the first insulator through-holes 27a and the second insulator through-holes 27b penetrates the corresponding insulator 14 from a first main surface 14A to a second main surface 14B. The first through-hole electrodes 23 are formed respectively in the first insulator through-holes 27a, and the second through-hole electrodes 25 are respectively formed in the second insulator through-holes 27b.

The conductive members 15a are formed on the second main surfaces 14B of the insulators 14. The conductive members 15a are each provided so as to link the first insulator through-holes 27a in a row, or the second insulator through-holes 27b in a row, in arrangement direction. The conductive members 15a can be formed of the same material as that of the wiring members 15 described in the first embodiment. In the second embodiment, the conductive members 15a are connected to the insulators 14. However, the conductive members 15a may otherwise be fitted into the insulators 14.

### (Configuration of Solar Cells)

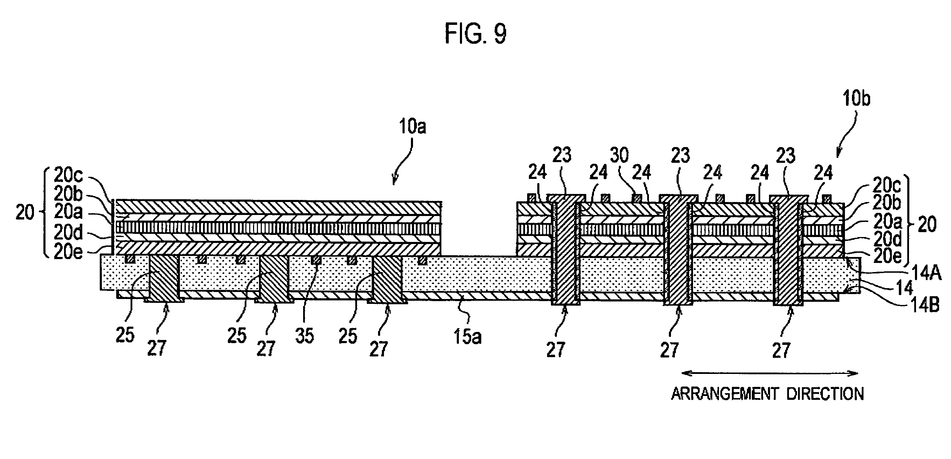

Fig. 9 is a cross-sectional view taken along a line D-D in Fig. 7. As shown in Fig. 9, the solar cell 10a and the solar cell 10b have the same configuration as that in the first embodiment. A conductive member is filled into each of the first insulator through-holes 27a to form the first through-hole electrode 23 therein, and a conductive member is filled into each of the second insulator through-holes 27b to form the second through-hole electrode 25 therein. The solar cell 10a and the solar cell 10b are electrically connected in series with the conductive members 15a.

### (Method of Manufacturing Solar Cell)

Next, a method of manufacturing the solar cells 10a and the solar cells 10b according to this embodiment will be described.

Firstly, photoelectric conversion parts 20 each including a first collector electrode 30 or a second collector electrode 35 formed thereon are arranged in the arrangement direction, while each being half-turned in relation to the adjacent photoelectric conversion parts 20.

The insulators 14 shown in Fig. 8 are then disposed respectively on pairs of the solar cell 10a and the solar cell 10b.

Subsequently, through-holes are formed in the photoelectric conversion parts 20 by applying CO₂ laser or an excimer laser to the inner sides of the first insulator through-holes 27a from the second main surface 14B side. Thereby, the first through-hole according to the first embodiment is formed.

Thereafter, an insulating material such as polysilazane is applied to the inner wall of each of the first through-holes, to provide insulation finishing (an insulating layer 24) therein.

Then, thermosetting conductive paste is filled into the first through-holes and the second insulator through-holes 27b by using a printing method such as a screen printing method. Thereby, the first through-hole electrodes 23 and the second through-hole electrodes 25 are formed.

A method of manufacturing the solar cell module is the same as that in the first embodiment.

### (Functions and Effects)

In the second embodiment, the insulators 14 are provided with the first insulator through-holes 27a and the second insulator through-holes 27b in advance.

Accordingly, after the insulators 14 are disposed on the solar cells 10a and the solar cells 10b, positions in which the first through-hole electrodes 23 and the second through-hole electrodes 25 are to be formed can easily be determined. Specifically, the through-holes can be formed in the photoelectric conversion parts 20 by using the positions of the first insulator through-holes 27a as markers.

In addition, in the second embodiment, the insulators 14 are provided with the conductive members 15a. The conductive members 15a are each formed so as to link the first insulator through-holes 27a of a row, or the second insulator through-holes 27b of a row.

Accordingly, the solar cells 10a and the solar cells 10b can be electrically connected to each other by filling a conductive member into each of the first insulator through-holes 27a and the second insulator through-holes 27b. This makes it possible to omit a step of thermally bonding the wiring members to the second main surfaces 14B of the insulators 14.

### [Third Embodiment]

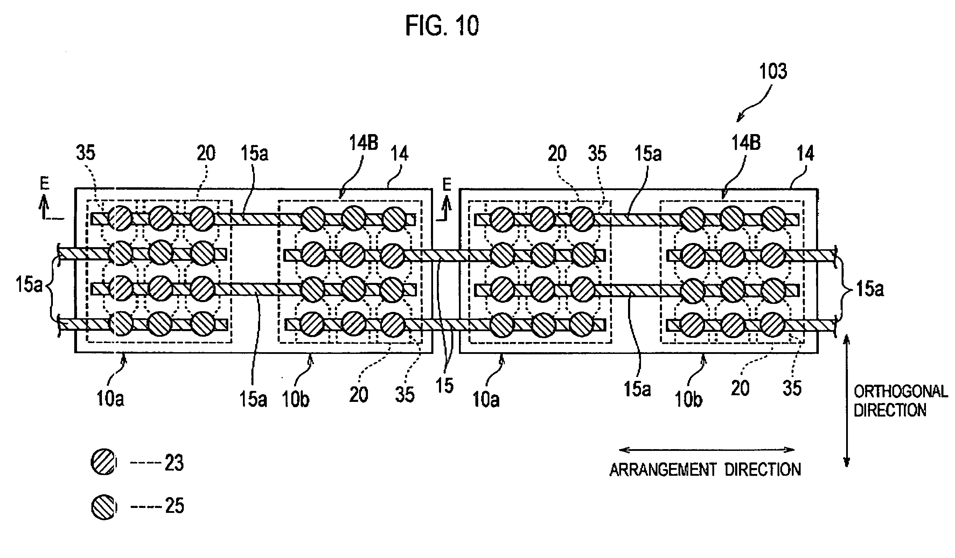

The third embodiment will be described below with reference to Figs. 10 to 13. In the third embodiment, through-holes formed in insulators 14 are each filled with a conductive member in advance. In the following description, explanations of portions the same as or similar to those in the second embodiment are omitted.

### (Configuration of Solar Cell String)

Fig. 10 is a back view of a solar cell string 103 according to the third embodiment. As shown in Fig. 10, the solar cell string 103 according to the third embodiment has the same configuration as that of the solar cell string 102 in the second embodiment.

### (Configuration of Insulators)

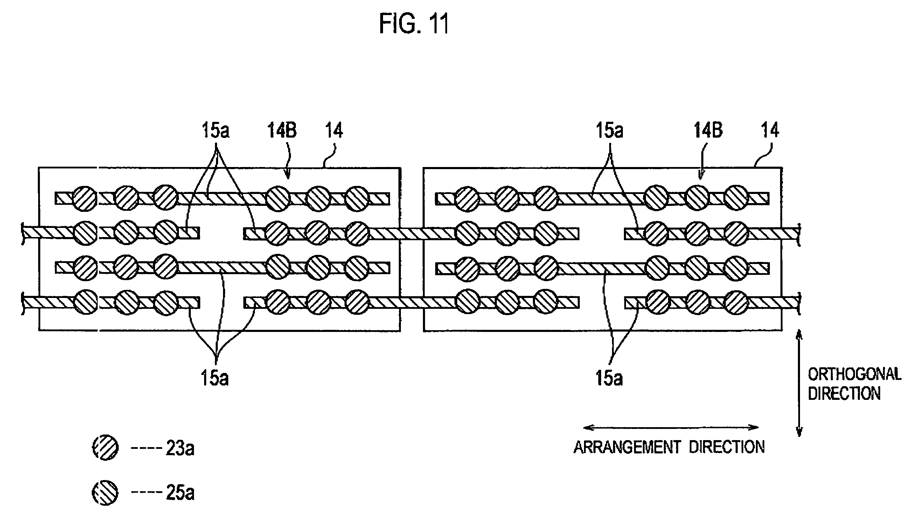

Fig. 11 is a back view of insulators 14 according to the third embodiment. The insulators 14 are each provided with first insulator-side conductive portions 23a, second insulator-side conductive portions 25a, and conductive members 15a.

Through-holes penetrating the corresponding insulator 14 from a first main surface 14A to a second main surface 14B (which are the first insulator through-holes 27a in the second embodiment; see Fig. 8) are filled with the first insulator-side conductive portions 23a, respectively. The first insulator-side conductive portions 23a each form part of the corresponding first through-hole electrode 23, as will be described later. The first insulator-side conductive portions 23a can be formed of thermosetting conductive paste, so-called ceramic paste, or the like.

Through-holes penetrating the corresponding insulator 14 from the first main surface 14A to the second main surface 14B (which are the second insulator through-holes 27b in the second embodiment; see Fig. 8) are filled with the second insulator-side conductive portions 25a, respectively. The second insulator-side conductive portions 25a can be formed of the same material as that of the first insulator-side conductive portions 23a.

The conductive members 15a are formed on the second main surfaces 14B of the insulators 14. The conductive members 15a are each provided so as to link the first insulator-side conductive portions 23a in a row, or the second insulator-side conductive portions 25a in a row, in arrangement direction. Accordingly, solar cells 10a and solar cells 10b are electrically connected to each other in series with the conductive members 15a.

### (Configuration of Solar Cells)

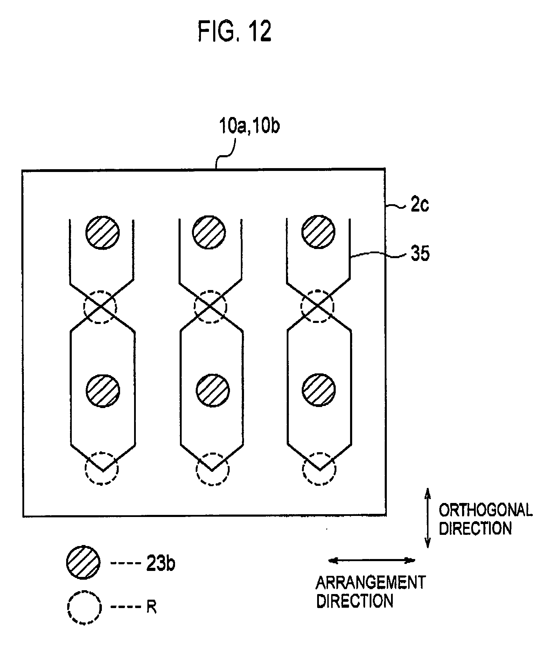

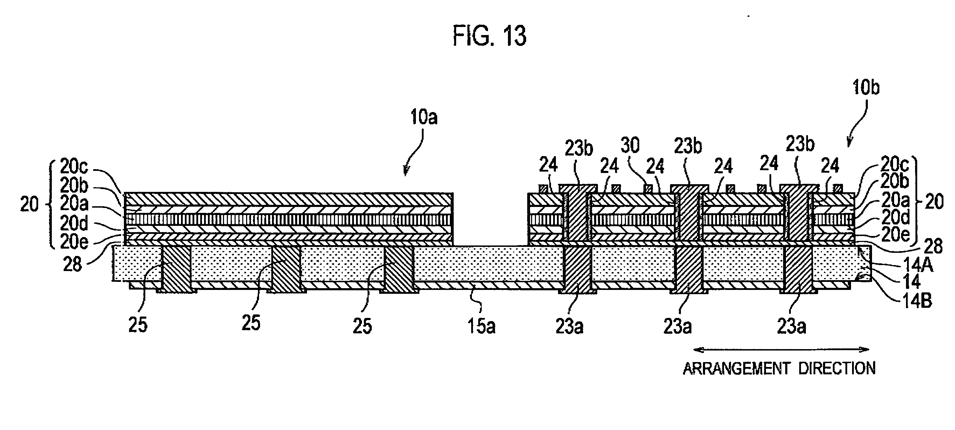

Fig. 12 is a back view of the solar cells 10a and 10b according to the third embodiment. Fig. 13 is a cross-sectional view taken along a line E-E in Fig. 10.

As shown in Fig. 12, the solar cells 10a and the solar cells 10b each include photoelectric conversion part-side conductive portions 23b and a second collector electrode 35.

As shown in Fig. 13, the photoelectric conversion part-side conductive portions 23b are formed in through-holes penetrating photoelectric conversion part 20 from a light-receiving surface to a back surface. The photoelectric conversion part-side conductive portions 23b are electrically connected to the first insulator-side conductive portions 23a, respectively, on the back-surface-side of the photoelectric conversion part 20. The first through-hole electrodes 23 are formed by the first insulator-side conductive portions 23a and the photoelectric conversion part-side conductive portions 23b electrically connected to each other in the above-described manner.

As shown in Fig. 12, the second collector electrode 35 is electrically connected to the second insulator-side conductive portions 25a in regions R. The second insulator-side conductive portions 25a serve as the second through-hole electrodes 25 by being connected to the second collector electrode 35.

Thus, in the third embodiment, the insulators 14 are connected to the photoelectric conversion parts 20; thereby, the first through-hole electrodes 23 and the second through-hole electrodes 25 are formed.

The insulators 14 according to the third embodiment are each connected to the corresponding photoelectric conversion parts 20 with an anisotropic conductive bonding materials 28, respectively, as shown in Fig. 13. As the anisotropic conductive bonding materials 28, a so-called an anisotropic conductive bonding material, which is a resin bonding material including a large number of conductive metallic particles, can be used. Specifically, the anisotropic conductive bonding materials 28 have electric conductivity in the directions substantially orthogonal to the first main surface 14A of the corresponding insulator 14. Accordingly, the first insulator-side conductive portions 23a and the photoelectric conversion part-side conductive portions 23b are electrically connected. Meanwhile, the anisotropic conductive bonding materials 28 have insulation properties in the directions substantially parallel to the first main surface 14A of the corresponding insulator 14. Accordingly, the first through-hole electrodes 23 are electrically separated from the back side of the corresponding photoelectric conversion part 20, the corresponding second collector electrode 35, and the corresponding second through-hole electrodes 25.

### (Functions and Effects)

In the third embodiment, the first insulator-side conductive portions 23a are formed in the insulators 14. Moreover, the photoelectric conversion part-side conductive portions 23b are formed in the photoelectric conversion parts 20.

Accordingly, the first through-hole electrodes 23 can be formed by electrically connecting the first insulator-side conductive portions 23a and the photoelectric conversion part-side conductive portions 23b, respectively. In other words, the first through-hole electrodes 23 can be formed by connecting the insulators 14 and the photoelectric conversion parts 20. With this configuration, the manufacturing process of the solar cells 10a and the solar cells 10b can be simplified.

In addition, the second insulator-side conductive portions 25a are formed in the insulators 14. In other words, the insulators 14 are provided with the second through-hole electrodes 25 in advance. With this configuration, the manufacturing process of the solar cells 10a and the solar cells 10b can be simplified.

Moreover, the insulators 14 and the photoelectric conversion parts 20 are connected with anisotropic conductive bonding materials 28. The anisotropic conductive bonding materials 28 have insulation properties in the directions parallel to the second main surface 14B of the corresponding insulator 14. Accordingly, the insulators 14 and the photoelectric conversion parts 20 can be connected easily, while the occurrence of short-circuit inside the solar cells 10a and the solar cells 10b can be reduced.

Furthermore, since the insulators 14 are provided with the conductive members 15a in advance, a step of thermally bonding wiring members on the second main surfaces 14B of the insulators 14 described in the first embodiment can be omitted.

### [Fourth Embodiment]

### (Schematic Configuration of Solar Cell Module)

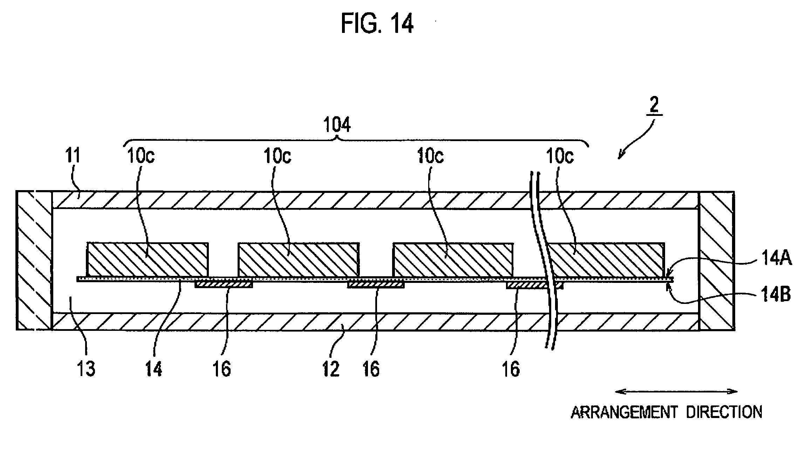

A schematic configuration of a solar cell module 2 according to the fourth embodiment will be described below with reference to Figs. 14 to 17. In the following description, explanations of portions the same as or similar to those in the first embodiment are omitted.

Fig. 14 is a side view of the solar cell module 2 according to the fourth embodiment. As shown in Fig. 14, the solar cell module 2 includes a solar cell string 104, a light-receiving-surface-side protection member 11, a back-surface-side protection member 12, and a sealing member 13.

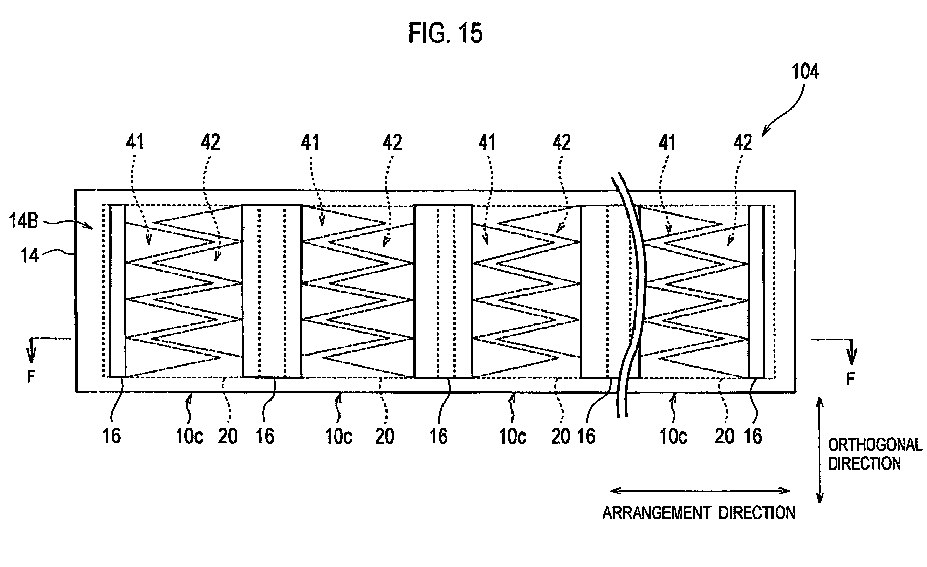

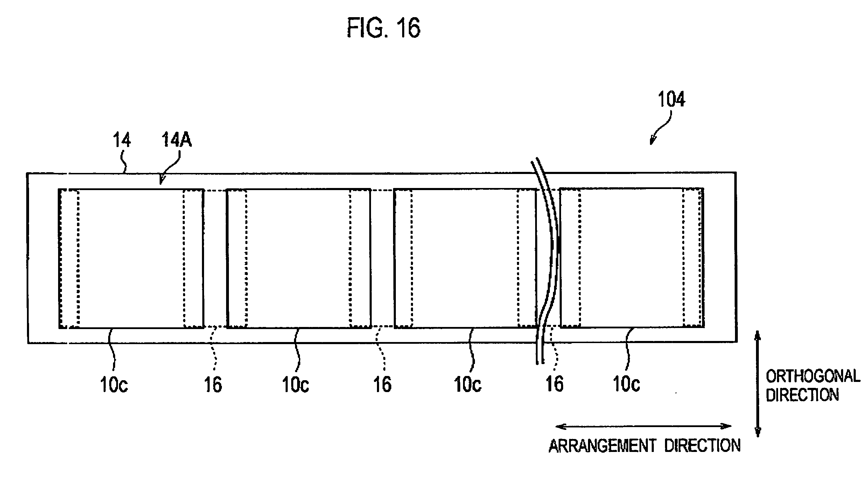

Fig. 15 is a back view of a solar cell string 104, and Fig. 16 is a top view of the solar cell string 104. As shown in Figs. 15 and 16, the solar cell string 104 includes multiple solar cells 10c and wiring members 16.

The multiple solar cells 10c are arranged in arrangement direction, and share an insulator 14. For the insulator 14, the same material as that in the first embodiment can be used.

The wiring members 16 are each disposed in a portion on a second main surface 14B of the insulator 14, the portion corresponding to the boundary between the solar cells 10c of each pair. One end of the wiring member 16 is electrically connected to a first collector electrode 41 included in one solar cell 10c through a first through-hole electrode 43 to be described later. The other end of each of the wiring members 16 is electrically connected to a second collector electrode 42 included in a different solar cell 10c adjacent to the one solar cell 10c, through a second through-hole electrode 45 to be described later. Thereby, the solar cells 10c are electrically connected to each other in series. The first collector electrode 41 and the second collector electrode 42 are formed on back surfaces of photoelectric conversion parts 40 to be described later.

### (Configuration of Solar Cells)

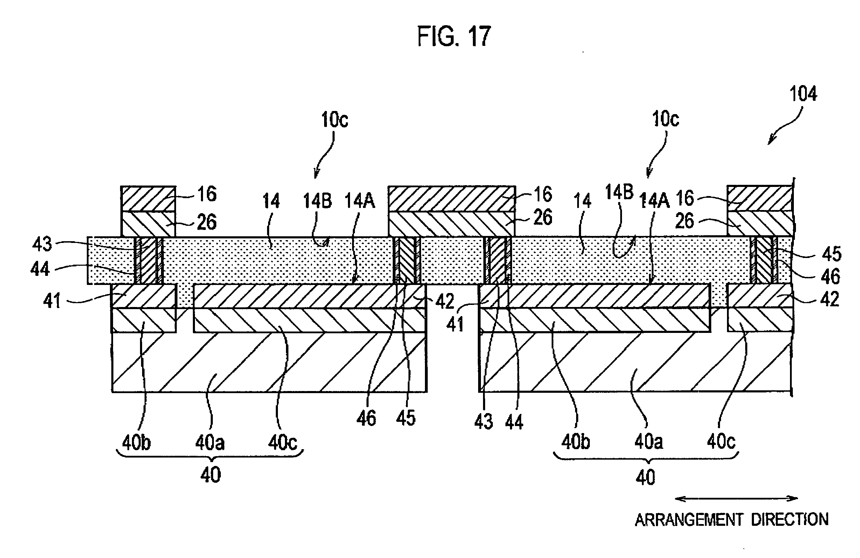

Next, a configuration of the solar cells 10c will be described with reference to Fig. 17. Fig. 17 is an enlarged cross-sectional view taken along a line F-F in Fig. 15.

The solar cells 10c each include the insulator 14, the photoelectric conversion part 40, the first collector electrode 41, the second collector electrode 42, a first through-hole electrode 43, a first insulating layer 44, a second through-hole electrode 45, and a second insulating layer 46.

The photoelectric conversion parts 40 each include a light-receiving surface (a lower surface in Fig. 17) through which light comes into the photoelectric conversion part 40, and a back surface (an upper surface in fig. 17) reverse of the light-receiving surface. The photoelectrical converter 40 generates photocarriers by receiving light coming thereinto through the light-receiving surface.

The photoelectric conversion part 40 has a semiconductor junction, such as a semiconductor p-n junction or a semiconductor p-i-n junction, as a fundamental structure. Specifically, the photoelectric conversion parts 40 each have a semiconductor substrate 40a, a first semiconductor region 40b, and a second semiconductor region 40c, as shown in Fig. 17. The semiconductor substrate 40a can be formed of a crystal-based semiconductor material such as single crystal Si or polycrystalline Si, or the like. The first semiconductor region 40b and the second semiconductor region 40c have different conductivity types.

The first collector electrode 41 is formed on the first semiconductor region 40b in the back surface of the photoelectric conversion part 40. The second collector electrode 42 is formed on the second semiconductor region 40c of the back surface of the photoelectric conversion part 40.

The first through-hole electrode 43 penetrates the insulator 14 from the first main surface 14A to the second main surface 14B. One end of the first through-hole electrode 43 is electrically connected to the first collector electrode 41. The other end of the first through-hole electrode 43 is electrically connected to the corresponding wiring member 16 through a conductive bonding material 26. Here, the first through-hole electrodes 43 each extend in orthogonal direction substantially orthogonal to the arrangement direction, although not shown in Fig. 17.

The first insulating layer 44 covers the peripheral surface of the corresponding first through-hole electrode 43.

The second through-hole electrode 45 penetrates the insulator 14 from the first main surface 14A to the second main surface 14B. One end of the second through-hole electrode 45 is electrically connected to the second collector electrode 42. The other end of the second through-hole electrode 45 is electrically connected to the corresponding wiring member 16 through the conductive bonding material 26. Here, the second through-hole electrodes 45 each extend in the orthogonal direction, although not shown in Fig. 17.

The conductive bonding materials 26 are each provided between the corresponding wiring member 16 and first through-hole electrode 43 as well as between the corresponding wiring member 16 and second through-hole electrode 45. As the conductive bonding materials 26, resin bonding material containing conductive metallic particles or solder can be used. (Functions and Effects)

In the fourth embodiment, the multiple solar cells 10c each include the insulator 14 connected to the back surface of the corresponding photoelectric conversion part 40.

With this configuration, the insulator 14 can absorb contraction force or expansion force of the wiring members 16 associated with temperature change. Accordingly, the photoelectric conversion parts 40 are less likely to curve due to contraction force or expansion force of the wiring members 16. Consequently, the solar cells 10c are less likely to be cracked or chipped.

Moreover, the solar cells 10c according to the fourth embodiment are each a so-called back-junction solar cell in which the first semiconductor region 40b and the second semiconductor region 40c having different conductivity type are formed on the back surface of the photoelectric conversion part 40. With this configuration, no collector electrode is formed on the light-receiving surface of each of the photoelectric conversion parts 40. Accordingly, light-receiving areas can be expanded.

### [Fifth Embodiment]

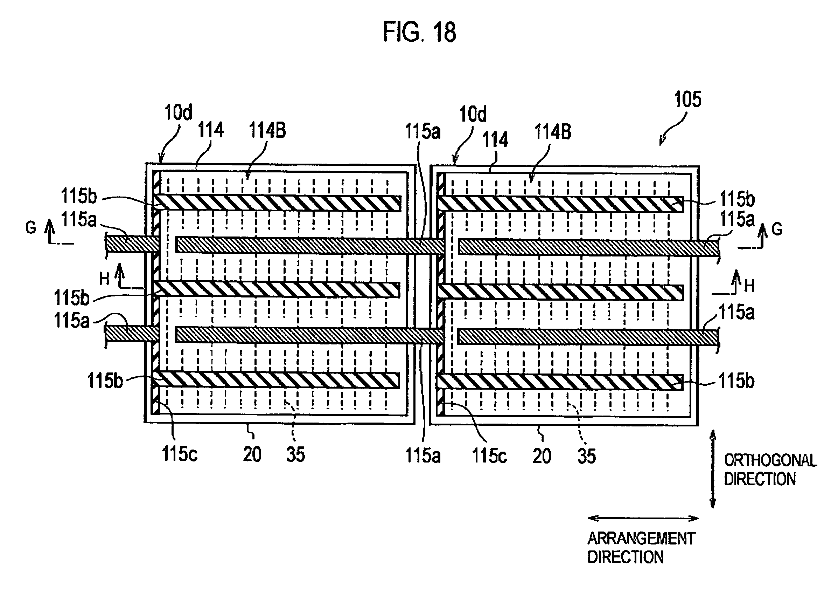

A fifth embodiment will be described below with reference to Figs. 18 to 22. In the fifth embodiment, a wiring member extending in orthogonal direction is disposed on the insulators. In the following description, explanations of parts the same as or similar to those in the first embodiment are omitted.

### (Configuration of Solar Cell String)

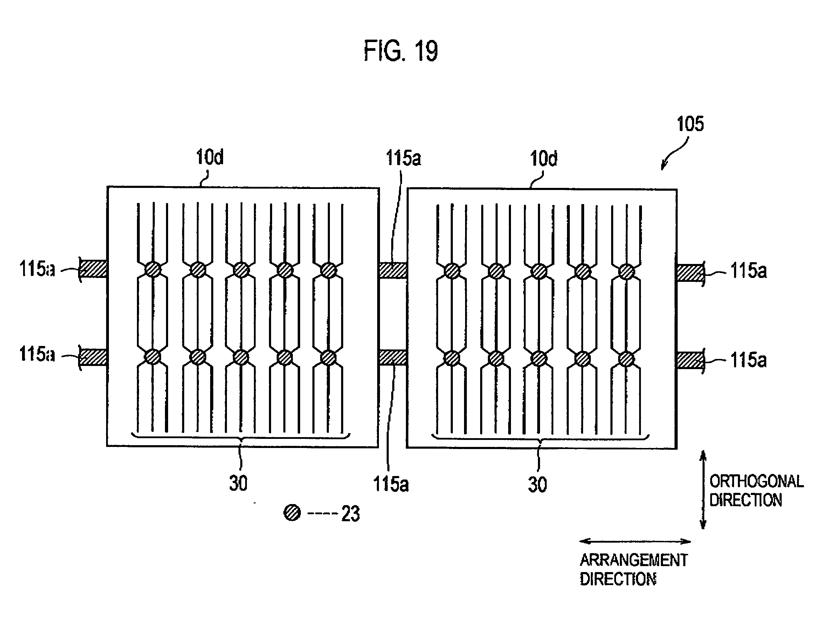

Fig. 18 is a back view of a solar cell string 105 according to the fifth embodiment, and Fig. 19 is a top view of the solar cell string 105 according to the fifth embodiment.

As shown in Figs. 18 and 19, the solar cell string 105 includes multiple solar cells 10d, first wiring members 115a, and second wiring members 115b. The multiple solar cells 10d are arranged in the arrangement direction. The solar cells 10d each include an insulator 114 and a third wiring member 115c disposed on the insulator 114.

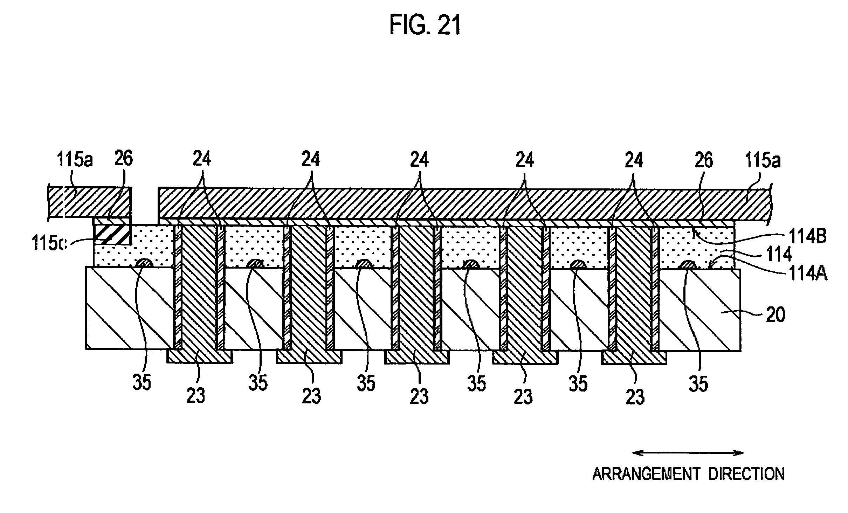

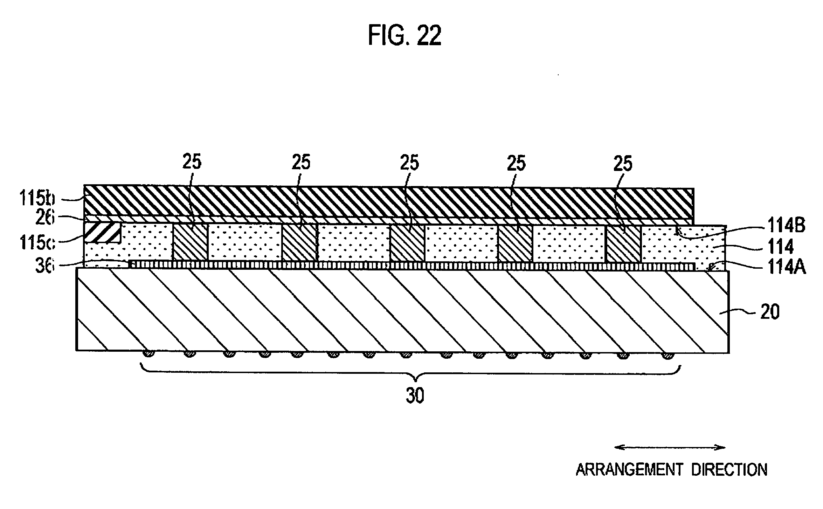

The first wiring members 115a and the second wiring members 115b are disposed on back surfaces of the solar cells 10d. Specifically, the first wiring members 115a and the second wiring members 115b are disposed on second main surfaces 114B of the insulators 114 of the solar cells 10d. Between the second main surface 114B of the corresponding insulator 114 and each of the first wiring members 115a and the second wiring members 115b, a conductive bonding material 26 is provided (see Figs. 21 and 22).

The first wiring members 115a and the second wiring members 115b are each arranged in the arrangement direction on the back surface of the corresponding solar cell 10d. In the fifth embodiment, two first wiring members 115a and three second wiring members 115b are alternately arranged in orthogonal direction on the solar cell 10d. The two first wiring members 115a disposed on the back surface of the solar cell 10d each extend toward the outside of the solar cell 10d, along the arrangement direction.

As shown in Fig. 18, one end of each of the second wiring members 115b disposed on the back surface of one solar cell 10d is electrically connected to the third wiring member 115c of the one solar cell 10d. One end of each of the first wiring members 115a disposed on the back surface of a different solar cell 10d adjacent to the one solar cell 10d is electrically connected to the third wiring member 115c of the one solar cell 10d. Thereby, the one solar cell 10d and the different solar cell 10d are electrically connected to each other in series.

Accordingly, when the solar cell string 105 is seen from the upper-surface side, the solar cells 10d appear to be connected to each other with two linear wiring members, as shown in Fig. 19. Thus, the configuration of the solar cell string 105 according to the fifth embodiment is more symmetric than that of the solar cell string 101 according to the first embodiment.

### (Configuration of Solar Cells)

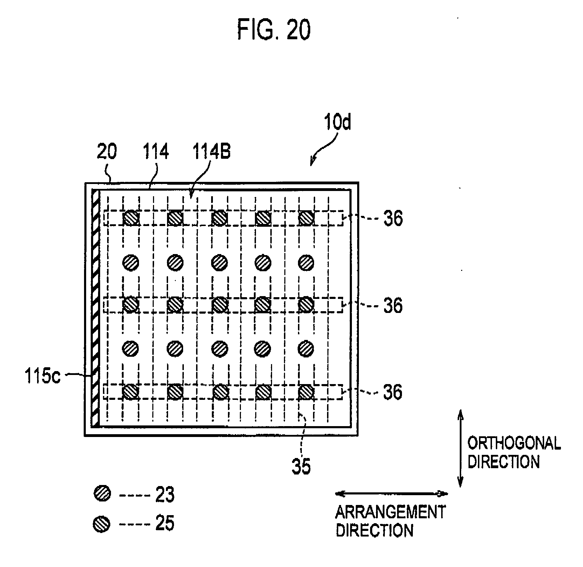

Fig. 20 is a back view of the solar cells 10d, Fig. 21 is an enlarged cross-sectional view taken along a line G-G in Fig. 18, and Fig. 22 is an enlarged cross-sectional view taken along a line H-H in Fig. 18.

As shown in Figs. 20 to 22, the solar cells 10d each include the insulator 114, the third wiring member 115c, a photoelectric conversion part 20, first through-hole electrodes 23, insulating layers 24, second through-hole electrodes 25, a first collector electrode 30, a second collector electrode 35, and third collector electrodes 36.

In the fifth embodiment, five first through-hole electrodes 23 arranged in the arrangement direction are arranged in two rows along the orthogonal direction. One end of each of the first through-hole electrodes 23 is electrically connected to the first collector electrode 30, on the light-receiving-surface side of the corresponding photoelectric conversion part 20. The other end of each of the first through-hole electrodes 23 is electrically connected to the corresponding first wiring member 115a, on the side of the second-main surface 114B of the corresponding insulator 114.

In the fifth embodiment, five second through-hole electrodes 25 arranged in the arrangement direction are arranged in two rows along the orthogonal direction. One end of each of the second through-hole electrodes 25 is electrically connected to the corresponding third collector electrode 36, on the side of a first-main surface 114A of the corresponding insulator 114. The other end of each of the second through-hole electrodes 25 is electrically connected to the corresponding second wiring member 115b, on the side of the second-main surface 114B of the insulator 114.

Here, the first through-hole electrodes 23 and the second through-hole electrodes 25 are alternately arranged in the orthogonal direction. Each row of the first through-hole electrodes 23 of one solar cell 10d is not in alignment with any row of the second through-hole electrodes 25 of a different solar cell 10d adjacent to the one solar cell 10d. Similarly, each row of the second through-hole electrodes 25 of the one solar cell 10d is not in alignment with any row of the first through-hole electrodes 23 of the different solar cell 10d adjacent to the one solar cell 10d.

The third collector electrodes 36 collect, from the photoelectric conversion part 20, photocarriers collected by the second collector electrode 35. In the fifth embodiment, the third collector electrodes 36 are each formed in the arrangement direction approximately in full length of the solar cell 10d, as shown in Fig. 20. The third wiring member 115c is disposed between the third collector electrodes 36 and the arrangement-direction end portion of the corresponding insulator 114.

The insulators 114 are each disposed on the back surface of the corresponding photoelectric conversion part 20. The third wiring member 115c is fitted into the insulator 114.

As shown in Figs. 21 and 22, the third wiring member 115c is disposed in the arrangement-direction end portion of the insulator 114. The first wiring members 115a and the second wiring members 115b are disposed on the third wiring member 115c with conductive bonding materials 26 interposed therebetween.

Here, the third wiring member 115c is fitted into the second main surface 114B of the insulator 114, and thereby integrated into the insulator 114. Accordingly, a surface of the third wiring member 115c horizontally continues to the second main surface 114B of the insulator 114, as shown in Figs. 21 and 22.

### (Functions and Effects)

The solar cells 10d according to the fifth embodiment include the third wiring members 115, respectively. One end of each of the three second wiring members 115b disposed on the back surface of one solar cell 10d is electrically connected to the third wiring member 115c of the one solar cell 10d. One end of each of the two first wiring members 115a disposed on the back surface of a different solar cell 10d adjacent to the one solar cell 10d is electrically connected to the third wiring member 115c of the one solar cell 10d.

Thus, the two first wiring members 115a and the three second wiring members 115b are electrically connected to each other with the third wiring member 115c. Accordingly, even when the number of the first wiring members 115a and the number of the second wiring members 115b disposed on the back surface of each of the solar cells 10d are different, the solar cells 10d can easily be connected to each other.

The solar cells 10d each have a symmetric configuration in both the arrangement direction and the orthogonal direction. Accordingly, the solar cells 10d need not be half-turned although the solar cells 10a and the solar cells 10b are half-turned in relation to each other as described in the first embodiment. Consequently, a manufacture process of the solar cell string 105 can be simplified.

In addition, the two first wiring members 115a and the three second wiring members 115b are electrically connected to each other with the third wiring member 115c. Accordingly, when the solar cell string 105 is seen from the upper-surface side, the solar cells 10d appear to be connected to each other with two first wiring members 115a each linearly extending in the arrangement direction. With this configuration, the external appearance of the solar cell string 105 can be improved.

Moreover, the third wiring members 115c are disposed in the insulator 114, respectively. Accordingly, expansion force or contraction force of the third wiring members 115c associated with temperature change can be absorbed by the insulators 114. Consequently, the solar cells 10d are less likely to curve or be cracked.

Furthermore, the third wiring members 115c are fitted into the insulators 114, respectively. Accordingly, the first wiring members 115a and the second wiring members 115b can be disposed without experiencing any deformation.

### [Sixth Embodiment]

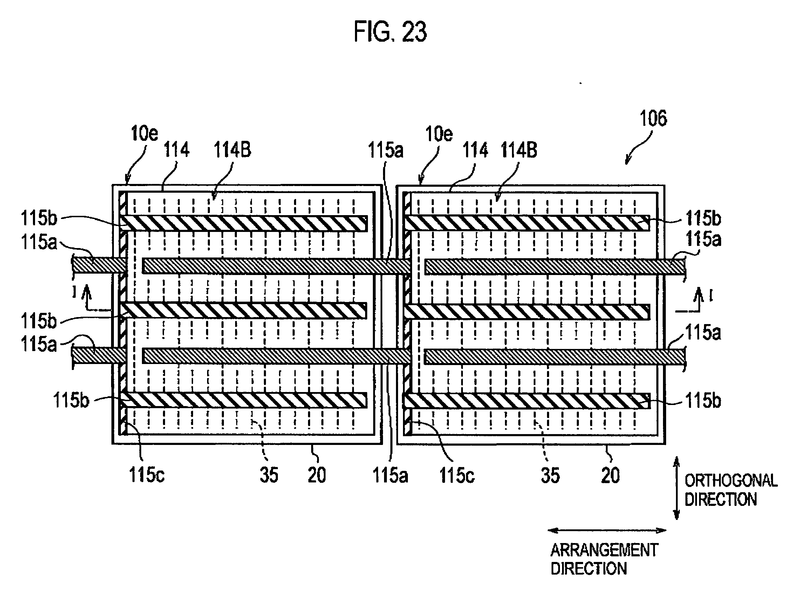

A sixth embodiment will be described below with reference to Figs. 23, 24, 25A, 25B, and 26. In the sixth embodiment, grooves each extending in arrangement direction are formed in insulators. In the following description, explanations of parts the same as or similar to those described in the fifth embodiment are omitted.

### (Configuration of Solar Cell String)

Fig. 23 is a back view of a solar cell string 106 according to the sixth embodiment. The solar cell string 106 according to the sixth embodiment has the same configuration as that of the solar cell string 105 according to the fifth embodiment.

### (Configuration of Solar Cells)

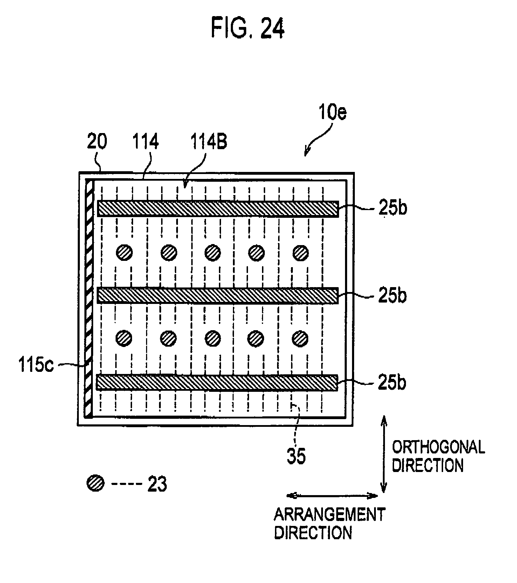

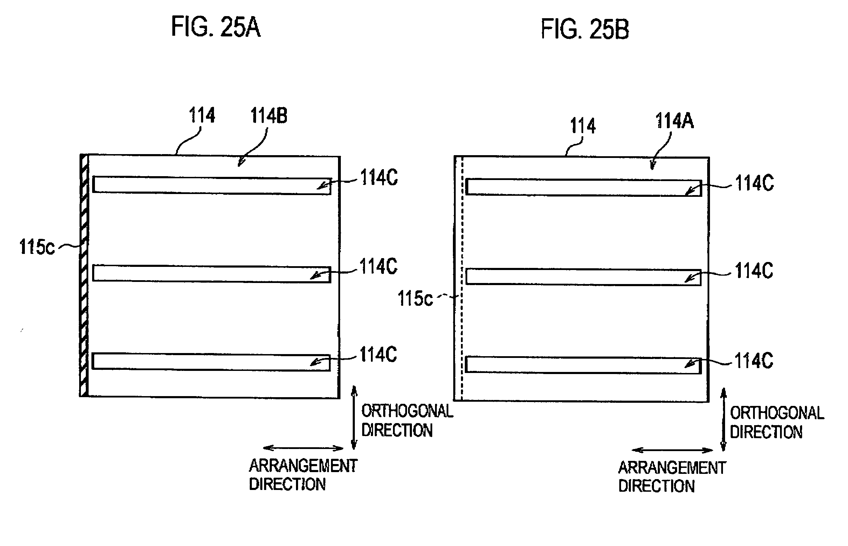

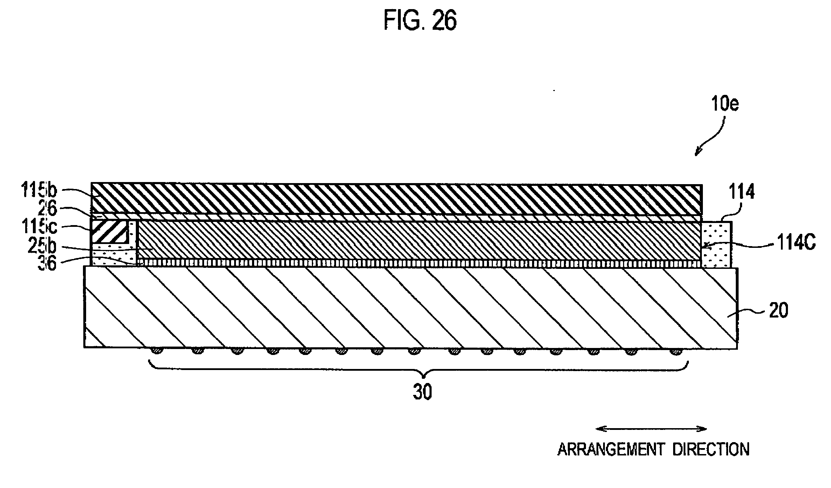

Fig. 24 is a back view of solar cells 10e according to the sixth embodiment. Fig. 25A is a back view of an insulator 114 of each of the solar cells 10e, and Fig. 25B is a top view of the insulator 114 of each of the solar cells 10e. Fig. 26 is an enlarged cross-sectional view taken along a line I-I in Fig. 23.

In the sixth embodiment, second through-hole electrodes 25b are disposed in the arrangement direction as shown in Fig. 24. Specifically, the second through-hole electrodes 25b are disposed in insulating grooves 114C formed in the insulators 114 to be described later.

As shown in Figs. 25A and 25B, the insulators 114 according to the sixth embodiment each include a first main surface 114A, a second main surface 114B, and three insulating grooves 114C. The first main surface 114A faces a back surface of a corresponding photoelectric conversion part 20. A second main surface 114B is on the reverse side of the first main surfaces 114A. The insulating grooves 114C are each arranged substantially parallel to the arrangement direction. The insulating grooves 114C each penetrate the insulator 114 from the first main surface 114A to the second main surface 114B.

As shown in Fig. 26, the second through-hole electrodes 25b are disposed in the insulating grooves 114C, respectively. The second through-hole electrodes 25b are arranged respectively on third collector electrodes 36, in the arrangement direction.

### (Functions and Effects)

In the sixth embodiment, the insulators 114 each includes the insulating grooves 114C formed in the arrangement direction. The second through-hole electrodes 25b are disposed in the insulating grooves 114C, respectively. The second through-hole electrodes 25b are arranged respectively on the third collector electrodes 36, in the arrangement direction.

Thus, the second through-hole electrodes 25b are disposed on the third collector electrodes 36, respectively. With this configuration, electric resistance between each of the second wiring members 115b and the corresponding third collector electrode 36 can be reduced, compared to a case in which the multiple second through-hole electrodes 25 are connected to the corresponding third collector electrode 36 as described in the fifth embodiment.

### [Seventh Embodiment]

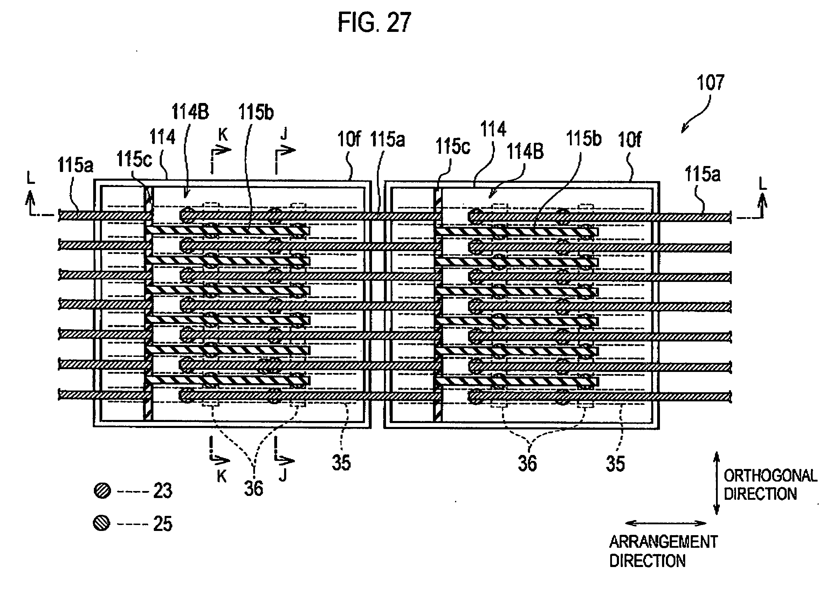

A seventh embodiment will be described below with reference to Figs. 27 to 32. In the seventh embodiment, third collector electrodes are each arranged in orthogonal direction. In the following description, explanations of parts the same as or similar to those in the fifth embodiment are omitted.

### (Configuration of Solar Cell String)

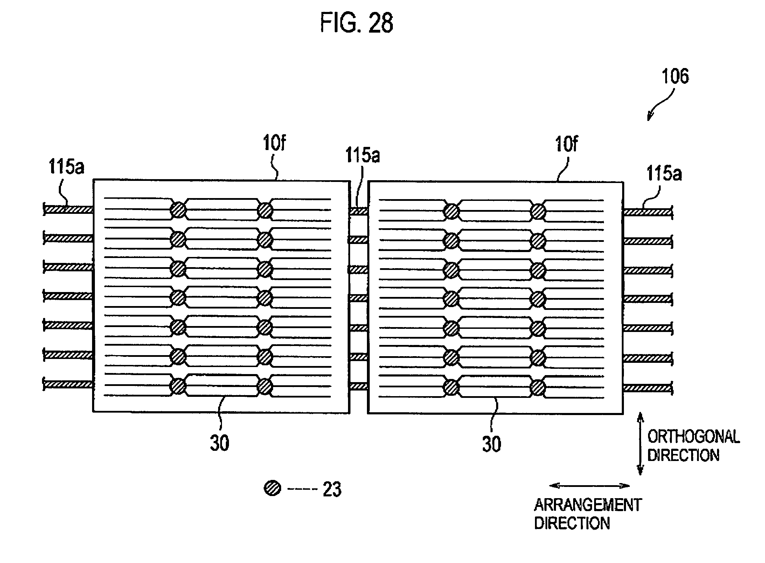

Fig. 27 is a back view of a solar cell string 107 according to the seventh embodiment, and Fig. 28 is a top view of the solar cell string 107 according to the seventh embodiment.

As shown in Figs. 27 and 28, the solar cell string 107 includes multiple solar cells 10f, first wiring members 115a, and second wiring members 115b. The solar cells 10f are arranged in arrangement direction. The solar cells 10f each include an insulator 114, and a third wiring member 115c disposed on the insulator 114.

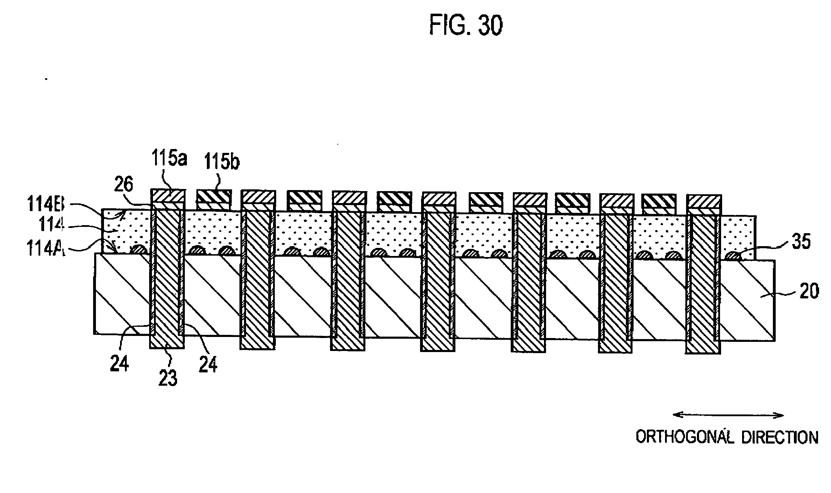

The first wiring members 115a and the second wiring members 115b are each disposed on a back surface of the corresponding solar cell 10f. Specifically, the first wiring members 115a and the second wiring members 115b are each disposed on a second main surface 114B of the insulator 114 of the corresponding solar cell 10f. A conductive bonding material 26 is provided between the second main surface 114B of the corresponding insulator 114 and each of the first wiring members 115a and the second wiring members 115b (see Figs. 30 to 32).

The first wiring members 115a and the second wiring members 115b are each arranged in the arrangement direction on the back surface of the corresponding solar cell 10f. In the seventh embodiment, seven first wiring members 115a and six second wiring members 115b are alternately arranged in the orthogonal direction on each of the solar cells 10f. Each of the seven first wiring members 115a disposed on the back surface of the corresponding solar cell 10f extends toward the outside of the solar cell 10f.

As shown in Fig. 27, one end of each of the second wiring members 115b disposed on the back surface of one solar cell 10f is electrically connected to the third wiring member 115c of the one solar cell 10f. One end of each of the first wiring members 115a disposed on the back surface of a different solar cell 10f adjacent to the one solar cell 10f is electrically connected to the third wiring member 115c of the one solar cell 10f. Thereby, the one solar cell 10f and the different solar cell 10f are electrically connected to each other in series.

Accordingly, as shown in Fig. 28, when the solar cell string 107 is seen from the upper-surface side, the solar cells 10f appear to be connected to each other with seven first wiring members 115a each linearly extending in the arrangement direction. Thus, the configuration of the solar cell string 107 according to the seventh embodiment is more symmetric than that of the solar cell string 101 according to the first embodiment.

### (Configuration of Solar cells)

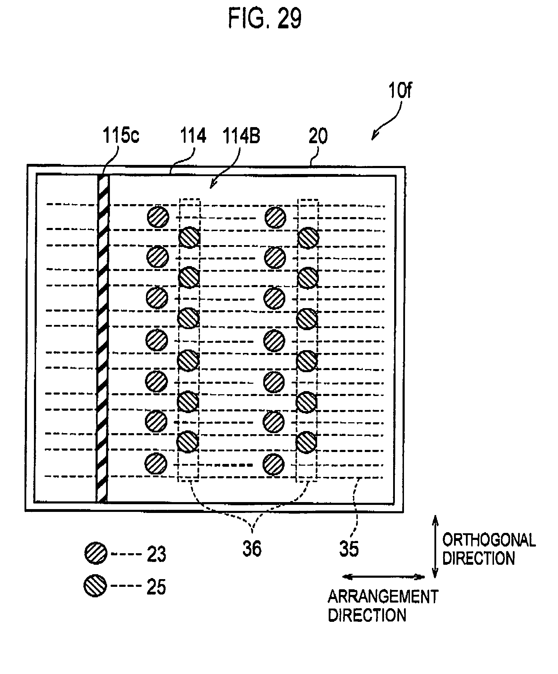

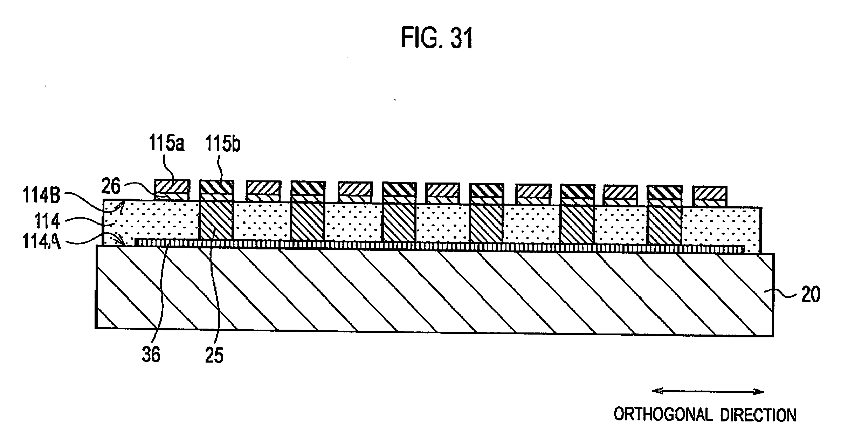

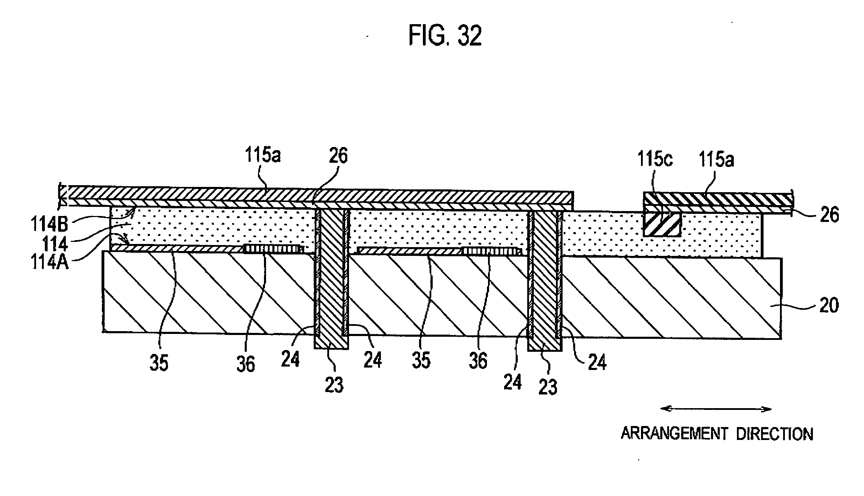

Fig. 29 is a back view of the solar cells 10f, Fig. 30 is an enlarged cross-sectional view taken along a line J-J in Fig. 27, Fig. 31 is an enlarged cross-sectional view taken along a ling K-K in Fig. 27, and Fig. 32 is an enlarged cross-sectional view taken along a line L-L in Fig. 27.

As shown in Figs. 29 to 32, the solar cells 10f each include the insulator 114, the third wiring member 115c, a photoelectric conversion part 20, first through-hole electrodes 23, insulating layers 24, second through-hole electrodes 25, a first collector electrode 30, a second collector electrode 35, and third collector electrodes 36.

In the seventh embodiment, two first through-hole electrodes 23 arranged in the arrangement direction are arranged in seven rows along the orthogonal direction. One end of each of the first through-hole electrodes 23 is electrically connected to the first collector electrode 30, on a light-receiving-surface side of the photoelectric conversion part 20. The other end of each of the first through-hole electrodes 23 is electrically connected to the corresponding first wiring member 115a, on the side of the second-main surface 114B of the insulator 114.

In the seventh embodiment, two second through-hole electrodes 25 arranged in the arrangement direction are arranged in six rows along the orthogonal direction. One end of each of the second through-hole electrodes 25 is electrically connected to the corresponding third collector electrode 36, on the side of the first-main surface 114A of the insulator 114. The other end of each of the second through-hole electrodes 25 is electrically connected to the second wiring member 115b, on the side of the second-main surface 114B of the insulator 114.

The third collector electrodes 36 collect, from the photoelectric conversion part 20, photocarriers collected by the second collector electrode 35. In the seventh embodiment, the third collector electrodes 36 each are formed approximately in full length of the solar cell 10f in the orthogonal direction, as shown in Fig. 29. The second through-hole electrodes 25 are formed on the corresponding third collector electrode 36.

The insulator 114 is disposed on a back surface of the photoelectric conversion part 20. The third wiring member 115c is fitted into the insulator 114.

Specifically, the third wiring member 115c is disposed between an arrangement-direction end portion of the insulator 114 and the seven first through-hole electrodes 23 arranged on the arrangement-direction-end-portion side of the insulator 114 as shown in Fig. 32. Here, the third wiring member 115c may be disposed anywhere between the arrangement-direction end portion of the insulator 114 and the seven first through-hole electrodes 23, although being disposed at the midway point therebetween in the seventh embodiment.

The third wiring member 115c is fitted into the second main surface 114B of the insulator 114, and is thereby integrated into the insulator 114.

### (Functions and Effects)

The solar cells 10f according to the seventh embodiment each include the insulator 114, the third wiring member 115c, the first through-hole electrodes 23, the second through-hole electrodes 25, and the third collector electrodes 36. The second through-hole electrodes 25 are each electrically connected to the corresponding third collector electrode 36. The third collector electrodes 36 are each arranged in the orthogonal direction.

With this configuration, the third wiring members 115c can each be disposed between the arrangement-direction end portion of the corresponding insulator 114 and the corresponding first through-hole electrodes 23, regardless of positions in which the third collector electrodes 36 are disposed. Accordingly, positions of the third wiring member 115c can be determined freely compared to a case in which the third collector electrodes 36 are each disposed in the arrangement direction as described in the fifth embodiment. In other words, the third wiring member 115c can be disposed anywhere between the arrangement-direction end portion of the insulator 114 and the first through-hole electrodes 23.

### (Other Embodiments)

Hereinabove, the present invention has been described with reference to the embodiments. However, the description and the drawings constituting parts of this disclosure are not construed to limit the invention. Various alternative embodiments, examples, and operation techniques will be obvious to those skilled in the art, on the basis of this disclosure.

For example, although the multiple solar cells 10 share the single insulators 14 in the above first to fourth embodiments, the number of the solar cells 10 which share the single insulator 14 is not limited. Accordingly, the single solar cell 10 may be provided for the single insulator 14.

In addition, a solar cell 10 may further include a third collector electrode for collecting photocarriers from a second collector electrode in the above first to fourth embodiments, although such a configuration is not described in these embodiments.

Multiple p-type regions and multiple n-type regions may each be formed finely in arrangement direction in the fourth embodiment, although such a configuration is not described in this embodiment. The present invention can also be applied to the back-junction solar cell 10 having such a configuration.

In the above first to third and fifth to seventh embodiments, the solar cell 10 includes the first collector electrode 30 and the second collector electrode 35. However, the solar cell 10 need not include any of such collector electrodes. In this case, the transparent conductive films 20c and 20e explained as parts of the photoelectric conversion part 20 serve as collector electrodes, instead.

Although the second collector electrode 35 is formed so as to have a pattern consists of lines, in the first to third and fifth to seventh embodiments, the shape of the second collector electrode 35 is not limited thereto.

The third wiring member 115c may be disposed between the two solar cells 10 in the fifth to seventh embodiments, although such a configuration is not described in these embodiments. Moreover, the third wiring member 115c need not be disposed on the insulator 114, and may be disposed on the photoelectric conversion part 20, instead. The shape of the third wiring member 115c is not limited in the present invention.

The number of wiring members is not limited in the present invention. Similarly, neither the numbers of the first through-hole electrodes 23 nor the second through-hole electrodes 25 are limited in the present invention.

Hence, it is obvious that the present invention includes various embodiments and the like not described herein. Accordingly, the technical scope of the present invention should only be defined by the claimed elements according to the scope of the claims reasonably understood from the above description.

## Claims

1. A solar cell module comprising:
a first solar cell; and
a second solar cell electrically connected to the first solar cell with a wiring member, wherein
the first solar cell and the second solar cell are arranged in arrangement direction,
the first solar cell and the second solar cell each include:
a photoelectric conversion part including a light-receiving surface and a back surface provided on a reverse side of the light-receiving surface, and configured to generate electrons and holes by receiving light;
a first collector electrode formed on the photoelectric conversion part, and configured to collect the electrons;
a second collector electrode formed on the photoelectric conversion part, and configured to collect the holes;
an insulator connected to the back surface of the photoelectric conversion part;
a first through-hole electrode penetrating the insulator, and electrically connected to the first collector electrode; and
a second through-hole electrode penetrating the insulator, and electrically connected to the second collector electrode, and
on the insulator, the wiring member is electrically connected to the first through-hole electrode included in the first solar cell and the second through-hole electrode included in the second solar cell.

2. The solar cell module according to claim 1, wherein
the first collector electrode is formed on the light-receiving surface of the photoelectric conversion part,
the second collector electrode is formed on the back surface of the photoelectric conversion part, and
the first through-hole electrode penetrates the photoelectric conversion part.

3. The solar cell module according to claim 1, wherein
the photoelectric conversion part includes:
an n-type region provided in the back surface; and
a p-type region provided in the back-surface,
the first collector electrode is disposed on the n-type region, and
the second collector electrode is disposed on the p-type region.

4. The solar cell module according to any one of claims 1 to 3, wherein the first through-hole electrode included in the first solar cell and the second through-hole electrode included in the second solar cell are linearly arranged in the arrangement direction, in a plan view from the back-surface side.

5. The solar cell module according to claim 1, wherein the insulator included in any one of the first solar cell and the second solar cell is formed of a resin material containing a plurality of particles.

6. The solar cell module according to claim 1, wherein surface processing is applied to the insulator included in any one of the first solar cell and the second solar cell, the surface processing for enabling the insulator to diffuse light.

7. The solar cell module according to claim 1, wherein the insulator included in the first solar cell and the insulator included in the second solar cell are integrally formed in a flat plate shape.

8. The solar cell module according to claim 1, wherein
the wiring member includes:
a first wiring member arranged in the arrangement direction, and connected to the first through-hole electrode included in the first solar cell; and
a second wiring member arranged in the arrangement direction, and connected to the second through-hole electrode included in the second solar cell,
the first solar cell includes a third wiring member arranged on the insulator in orthogonal direction substantially orthogonal to the arrangement direction, and
the first wiring member and the second wiring member are each electrically connected to the third wiring member.

9. The solar cell module according to claim 8, wherein
in a plan view from the back-surface side,
the first through-hole electrode included in the first solar cell and the second through-hole included in the second solar cell are disposed on a line intersecting the arrangement direction.

10. The solar cell module according to any one of claims 8 and 9, wherein
the first solar cell includes a third collector electrode electrically connected to the second collector electrode, and
the third collector electrode is formed in the orthogonal direction on the back surface of the photoelectric conversion part.

11. A solar cell comprising:
a photoelectric conversion part including a light-receiving surface and a back surface provided on a reverse side of the light-receiving surface, and configured to generate electrons and holes by receiving light;
a first collector electrode formed on the photoelectric conversion part, and configured to collect the electrons;
a second collector electrode formed on the photoelectric conversion part, and configured to collect the holes;
an insulator connected to the back surface of the photoelectric conversion part;
a first through-hole electrode penetrating the insulator, and electrically connected to the first collector electrode; and
a second through-hole electrode penetrating the insulator, and electrically connected to the second collector electrode.
